# EUROPÄISCHE PATENTSCHRIFT

(11) **EP 4 584 112 B1**
(45) Veröffentlichungstag und Bekanntmachung des Hinweises auf die Patenterteilung: **04.11.2026**
(21) Anmeldenummer: 23765482.7
(22) Anmeldetag: 05.09.2023
(51) Int. Cl.: B60K 35/22, B60K 35/25, B60K 35/50, B60K 35/60, B60K 37/20, H03K 17/965, B60K 35/10

(54) **BEDIENVORRICHTUNG FÜR EIN FAHRZEUG**
OPERATING DEVICE FOR A VEHICLE
DISPOSITIF DE COMMANDE POUR VÉHICULE

(30) Priorität: 06.09.2022 DE 102022122571
(43) Veröffentlichungstag der Anmeldung: 16.07.2025
(73) Patentinhaber: AUO Mobility Solutions Germany GmbH, 59557 Lippstadt (DE)
(72) Erfinder: WOLF, Robin, 33102 Paderborn (DE); VÄLIMÄKI, Pyry, 33310 Tampere (FI); KEMPPINEN, Pasi, 33800 Tampere (FI); BANDLOW, Bastian, 33100 Paderborn (DE)
(74) Vertreter: dompatent
(86) Internationale Anmeldenummer: PCT/EP2023/074257
(87) Internationale Veröffentlichungsnummer: WO 2024/052312

(56) Entgegenhaltungen:
- DE-A1- 102018 109 321
- DE-A1- 102020 108 495
- US-A1- 2017 148 587
- US-A1- 2019 338 561

## Beschreibung

Die Erfindung betrifft eine Bedienvorrichtung für ein Fahrzeug und insbesondere eine Bedienvorrichtung mit einer langgestreckten, streifenförmigen, geschlossenen Bedienoberfläche mit nebeneinander angeordneten Bedienfeldern, an denen manuell mit einem Finger oder einem Objekt gedrückt werden kann, um die dem Bedienfeld zugeordnete Funktion auszulösen.

Bedienkonzepte für Fahrzeuge mit sogenannten "geschlossenen" Bedienoberflächen erfreuen sich zunehmender Beliebtheit. Derartige geschlossene Bedienoberflächen gewährleisten den Schutz vor in die Bedienvorrichtung potenziell eindringbarer Feuchtigkeit und zeichnen sich überdies dadurch aus, dass nicht jedem Bedienfeld ein separater Schalter zugeordnet werden muss, wie es beispielsweise bei der Anordnung einzelner Bedientasten der Fall ist (siehe z.B. WO-A-2019/215177, DE-B-10 2016 002 021 und KR-B-10 1 187 478).

Die Erkennung einer validen Betätigung einer Bedienoberfläche mit mehreren Bedienfeldern macht es erforderlich, dass unabhängig davon, welches der Bedienfelder berührt und damit an welchem Ort auf der Bedienoberfläche gegen diese gedrückt wird, die gesamte Bedienfläche eine Mindestandrückkraft erfährt, die entweder direkt oder als von der Bedienoberfläche "zurückgelegter" Mindestweg erkannt wird. Wenn die Bedienoberfläche aus einem vergleichsweise steifen oder starren Material, wie z.B. einer verhältnismäßig dicken Glasscheibe besteht, so ist diese Voraussetzung mit einer vergleichsweise einfachen Konstruktion realisierbar, und zwar auch dann, wenn für die Erkennung der Aufbringung der Mindestandrückkraft nur ein einziger Betätigungssensor vorhanden ist. Dieser sollte dann bezogen auf die Bedienoberfläche an zentraler Stelle angeordnet sein. Auch sind Bedienkonzepte mit linear geführten Bedienelementen bekannt, deren Bedienoberflächen beim Betätigen ihre parallele Ausrichtung beibehalten.

Aufgrund größerer Designfreiheiten, was die geometrische Ausgestaltung der Bedienoberflächen von Bedienvorrichtungen betrifft, geht man mehr und mehr dazu über, die die Bedienoberflächen bildenden Bedienelemente aus Kunststoff zu fertigen. Kunststoff allerdings ist weniger biegesteif und spürbar flexibel, so dass es schwierig wird, einer langgestreckten beispielsweise schmalen Bedienoberfläche aus Kunststoff mit mehreren nebeneinanderliegenden Bedienfeldern lediglich einen einzigen Betätigungssensor zuzuordnen, der unabhängig davon, an welchem Bedienfeld die Bedienoberfläche betätigt wird, gleichermaßen zuverlässig mechanisch eine valide Betätigung der Bedienoberfläche zu signalisieren. Im Gegensatz zu biegesteifen Bedienelementen bzw. -oberflächen, die sich beim Niederdrücken quasi parallel verschieben oder die dabei kippen, können sich Bedienelemente bzw. -oberflächen aus Kunststoff bei Krafteinwirkung durchbiegen.

Ferner kann das Kunststoffmaterial auch beim aktiven haptischen Feedback Probleme bereiten, so dass auch diesbezüglich dafür Sorge getragen werden sollte, dass sich die mechanische puls- bzw. vibrationsartige Anregung des Bedienelements unabhängig davon, welches Bedienfeld gerade niedergedrückt wird, gleich verhält.

Aus US-A-2017/148587 ist eine Bedienvorrichtung nach dem Oberbegriff des Anspruchs 1 bekannt.

Bedienvorrichtungen mit steifen niederdrückbaren, Bedienfelder aufweisenden Bedienplatten sind aus DE-A-10 2020 108 495, DE-A-10 2018 109 321 und US-A-2019/338561 bekannt.

Aufgabe der Erfindung ist es, eine diesbezüglich verbesserte Bedienvorrichtung für ein Fahrzeug zu schaffen, die sich durch einen einfachen Aufbau bei Verwendung einer möglichst geringen Anzahl von Komponenten zur Parallelführung des Bedienelements sowohl beim Niederdrücken als auch bei der mechanischen Anregung für das aktive haptische Feedback auszeichnet.

Zur Lösung dieser Aufgabe wird mit der Erfindung eine Bedienvorrichtung für ein Fahrzeug vorgeschlagen, die versehen ist mit
- einem Gehäuse, das eine Vorderseite mit einer Aussparung aufweist, die sich zwischen zwei gegenüberliegenden Auflagerandabschnitten an der Vorderseite des Gehäuses erstreckt,
- einer elastischen und/oder direkt oder indirekt elastisch gelagerten Bedienplatte, die zwei gegenüberliegende Auflageenden zur Auflage auf den beiden Auflagerandabschnitten, an denen die Bedienplatte an dem Gehäuse gelagert und/oder befestigt ist, aufweist und die Aussparung überdeckt,
- wobei die Bedienplatte reversibel aus einer Ruheposition bis in eine Betätigungsposition niederdrückbar ist und eine Bedienfläche mit Bedienfeldern aufweist,
- einer Positionserkennungssensorik zur Erkennung desjenigen Bedienfeldes der Bedienfläche der Bedienplatte, das beim Niederdrücken manuell oder durch ein Objekt kontaktiert ist,
- einer im Gehäuse angeordneten Rückholblattfeder zur Unterstützung der Bewegung der niedergedrückten Bedienplatte zurück in deren Ruheposition,
- mindestens einem Betätigungssensor zur Erkennung der Einnahme der Betätigungsposition der Bedienplatte,
- mindestens einem Bewegungsübertragungselement zur Übertragung der Niederdrückbewegung der Bedienplatte in eine Verbiegung der Rückholblattfeder,
- wobei das mindestens eine Bewegungsübertragungselement zwischen der Bedienplatte und der Rückholblattfeder angeordnet ist und zwei gegenüberliegende, geradlinige Endabschnitte aufweist, von denen der erste Endabschnitt mit der Bedienplatte und der gegenüberliegende zweite Endabschnitt mit der Rückholblattfeder verbunden ist,
- einer Ansteuer- und Auswerteeinheit (typischerweise ausgebildet mit unter anderem einem Mikrocontroller, I/O-Ports, ADC, DAC, Speicher- und Signal- und/oder Datenverarbeitungsprozessor), die Signale von der Positionserkennungssensorik und dem mindestens einen Betätigungssensor empfängt und bei Erkennung einer validen Betätigung der Bedienplatte durch bei Berührung eines Bedienfeldes der Bedienfläche erfolgender Überführung der Bedienplatte bis in deren Betätigungsposition ein Ausgangssignal für dessen Weiterverarbeitung zur Auslösung einer dem betreffenden Bedienfeld zugeordneten Aktion ausgibt und
- einem Aktuator zur puls- oder vibrationsartigen Anregung der Bedienplatte bei einer validen Betätigung derselben,
- wobei der Aktuator durch ein von der Ansteuer- und Auswerteeinheit bei Erkennung einer validen Betätigung ausgegebenes Ausgangssignal ansteuerbar ist und
- wobei der Aktuator zur puls- oder vibrationsartigen Anregung der Bedienplatte mit der Rückholblattfeder zur Bewegung derselben zusammenwirkt oder auf diese einwirkt.

Die erfindungsgemäße Bedienvorrichtung weist ein Gehäuse auf, an dessen Vorderseite sich eine elastische und/oder (direkt oder indirekt) elastisch gelagerte Bedienplatte befindet. Die Bedienplatte weist zwei gegenüberliegende Auflageenden auf, an denen sie an dem Gehäuse anliegend befestig ist. Damit sich die Bedienplatte bei manueller Druckausübung leicht durchbiegen kann, weist das Gehäuse an seiner Vorderseite eine gegenüber zumindest in Teilen ihrer Umrandung zurückversetzte Aussparung in Form einer Vertiefung oder Mulde oder in Form einer Öffnung auf, so dass die Bedienplatte bei einer manuellen Betätigung zumindest geringfügig durchbiegbar ist. Während die Unterseite der Bedienplatte zur Aussparung des Gehäuses weist, befindet sich an ihrer Oberseite die Bedienoberfläche der Bedienvorrichtung, die mehrere typischerweise nebeneinanderliegende Bedienfelder zur manuellen Betätigung zwecks Eingabe von Befehlen durch an den Bedienfeldern erfolgendes Drücken gegen die Bedienplatte mit einer Mindestandrückkraft aufweist.

Die Durchbiegung der Bedienplatte wird mittels eines Betätigungssensors erfasst. Dies erfolgt aber nicht etwa direkt, sondern anhand der Bewegung eines mindestens einen Bewegungsübertragungselements (in der Folge wird der Einfachheit halber von "dem Bewegungsübertragungselement gesprochen, womit gemeint ist, dass dessen Eigenschaften und Ver- und Einbauumgebung für jedes weitere Bewegungsübertragungselement ebenfalls gilt, wobei zweckmäßigerweise zwei Bewegungsübertragungselemente als geeignet erscheinen), das seinerseits mit der Bedienplatte starr verbunden ist. Das Bewegungsübertragungselement weist einen geradlinigen Montagerandabschnitt auf, der parallel zur Längserstreckung der Bedienplatte verläuft und sich in etwa im mittleren Bereich der Bedienplatte befindet. Wird nun die Bedienplatte durch Drücken gegen die Bedienplatte an einem der Bedienfelder betätigt, so erfährt das Bewegungsübertragungselement einen der Durchbiegung entsprechenden Versatz nach unten, und zwar auch dann, wenn die Betätigung der Bedienplatte vergleichsweise nahe zu ihren Auflageenden erfolgt. Das Bewegungsübertragungselement wirkt mit einem (vorteilhafterweise) einzigen Betätigungssensor zusammen, der optisch, kapazitiv, resistiv oder induktiv arbeiten kann.

Durch die Versteifung der Bedienplatte im Bereich der Ankopplung an diese durch das Bewegungsübertragungselement wird erreicht, dass das Bewegungsübertragungselement unabhängig davon, wo auf der Bedienplatte gegen diese mit einer Mindestandrückkraft gedrückt wird, eine Mindestauslenkung erfährt, die von dem Betätigungssensor erfasst wird, womit eine insoweit valide Betätigung der Bedienvorrichtung erkannt werden kann. Zur Bestätigung, dass eine Bedienung der Bedienplatte valide ist, gehört dann noch, dass die Bedienplatte an einem Bedienfeld ihrer Bedienoberfläche berührt wird, wenn gegen die Bedienplatte gedrückt wird, was durch eine der Bedienoberfläche zugeordnete Berührungssensorik erfolgt, die kapazitiv, optisch, resistiv oder induktiv arbeiten kann.

Bei dem Bewegungsübertragungselement handelt es sich um ein Bauteil, das gegenüber im Wesentlichen normal zur Auflageplatte wirkenden Kräften widerstandsfähig sowie scherkraftfest ist. Der Betätigungssensor erfasst einen Lageversatz des Bewegungsübertragungselements, wenn gegen die Bedienplatte gedruckt wird.

Die erfindungsgemäße Bedienvorrichtung weist ferner einen Aktuator zur puls- oder vibrationsartigen Anregung der Bedienplatte bei einer validen Betätigung derselben auf. Der Aktuator wird durch ein von der Ansteuer- und Auswerteeinheit bei Erkennung einer validen Betätigung ausgegebenes Ausgangssignal angesteuert. Erfindungsgemäß wirkt der Aktuator für die puls- oder vibrationsartige Anregung der Bedienplatte auf die Rückholblattfeder ein, regt also mechanisch diese Rückholblattfeder an, deren mechanische Anregung durch das Bewegungsübertragungselement in eine puls- oder vibrationsartige Bewegung der Bedienplatte übertragen wird. Somit ist also nach der Erfindung vorgesehen, die Bedienplatte für das aktive haptische Feedback nicht direkt mechanisch anzuregen, sondern indirekt, und zwar vermittels ihrer Rückholfeder, also vermittels ihrer elastischen Lagerung. Mit Vorteil dient also das Bewegungsübertragungselement einer Vergleichmäßigung der Bewegung der Bedienplatte sowohl beim Niederdrücken als auch beim aktiven haptischen Feedback.

In vorteilhafter Ausgestaltung der Erfindung kann vorgesehen sein, dass der Aktuator als ein Zugankermagnet mit einem im Gehäuse gelagerten, mit einer Spule versehenen Stator und einem ferromagnetischen Anker ausgebildet ist und dass der Anker zur puls- oder vibrationsartigen Anregung der Rückholblattfeder mit dieser verbunden ist. In diesem Ausführungsbeispiel ist der Aktuator also als Zugankermagnet ausgebildet und weist einen "eigenen" ferromagnetischen Anker auf, der durch den die Spule erzeugten magnetischen Fluss im Stator angezogen oder abgestoßen wird. Der ferromagnetische Anker ist in diesem Ausführungsbeispiel mit der Rückholblattfeder fest verbunden. Alternativ dazu kann der Aktuator als ein Zugankermagnet mit einem im Gehäuse befestigten ferromagnetischen Anker und einem mit einer Spule versehenen Stator ausgebildet sein und der Stator zur puls- oder vibrationsartigen Anregung der Rückholblattfeder mit dieser verbunden sein. In diesem Ausführungsbeispiel ist es also der Stator, der mit der Rückholblattfeder fest verbunden ist. Es handelt sich also um eine Umkehrung des Zugankermagnetkonzepts gemäß vorherigen Ausführungsbeispiel.

In einer weiteren Variante kann der Aktuator als ein Zugankermagnet mit einem in dem Gehäuse gelagerten, mit einer Spule versehenen Stator und einem ferromagnetischen Anker aufweisen, wobei die Rückholblattfeder den ferromagnetischen Anker des Zugankermagneten zur puls- oder vibrationsartigen Anregung bildet. Damit reduziert sich die Anzahl der Bauteile für das aktive haptische Feedback.

In einer weiteren Variante für die Ausgestaltung des Aktuators ist dieser als ein Tauchspulenaktuator ausgebildet, der eine im Gehäuse befestigte Grundplatte, auf der sich eine Statorspule befindet, ein federelastisches, an der Grundplatte gelagertes und im Abstand zur Grundplatte angeordnetes Aktuatorelement und ein an dem Aktuatorelement angeordnetes, zumindest teilweise in die Statorspule eingetauchtes Permanentmagnetelement aufweist, wobei das Aktuatorelement zur puls- oder vibrationsartigen Anregung der Rückholblattfeder mit dieser verbunden ist.

In einer alternativen Ausgestaltung des Aktuators als Tauchspulenaktuator weit dieser eine im Gehäuse befestige Grundplatte, auf der oder an der eine Spule montiert ist, und ein zumindest teilweise in die Spule eingetauchtes Permanentmagnetelement auf, wobei das Permanentmagnetelement mit der Rückholblattfeder zur puls- oder vibrationsartigen Anregung verbunden ist. Auch hier ist also die Anzahl von Bauteilen für das aktive haptische Feedback reduziert.

Vorzugsweise handelt es sich im Falle der beiden Ausgestaltungen des Aktuators als Tauchspulenaktuator bei der Grundplatte um eine Leiterplatine, auf der die Spule beispielsweise durch Verkleben oder durch mechanische Befestigungsmittel und vorzugsweise durch Lötmaterial befestigt ist.

Alternativ kann man als Aktuator auch ein oder mehrere piezoelektrische Elemente verwenden, die platten- oder streifenförmig ausgebildet sind und zwei Hauptflächen sowie zwei Anschlusselemente bzw. Anschlüsse aufweisen, wobei das mindestens eine piezoelektrische Element bei einer an die Anschlusselemente angelegten elektrischen Spannung, je nach Polarität, kontrahiert oder expandiert, wobei das mindestens eine piezoelektrische Element mit einer seiner Hauptflächen an der Rückholblattfeder zur puls- oder vibrationsartigen Anregung anliegt sowie mit dieser starr verbunden ist, so dass eine schubsteife Verbindung zwischen dem oder den piezoelektrischen Elementen und der Rückholblattfeder gegeben ist.

Die bisherigen weiteren Ausgestaltungen der Konstruktionen für das aktive haptische Feedback beruhen auf der Ansteuerung des Aktuators, ohne dass eine Rückkopplung, also eine Regelung der pulsartigen bzw. vibrationsartigen Bewegung realisiert ist. In einer hinsichtlich einer Regelung vorteilhaften Ausgestaltung der Erfindung kann vorgesehen sein, dass die Ansteuer- und Auswerteeinheit einen Regler zur Regelung der Auslenkung der Bedienplatte bei puls- oder vibrationsartiger Anregung derselben infolge einer Aktivierung des Aktuators aufweist, wobei der Regler an seinem Eingang ein Differenzsignal aus einem eine Sollauslenkung der Bedienplatte repräsentierenden Signal und einem das während der puls- bzw. vibrationsartigen Anregung aktuelle Ausmaß der Auslenkung der Bedienplatte repräsentierenden Signal erhält und an seinem Ausgang ein Ansteuersignal für den Aktuator zur Regelung der Auslenkung der Bedienplatte entsprechend der Sollauslenkung ausgibt.

Die Rückholblattfeder der erfindungsgemäßen Bedieneinheit kann an einem Ende oder an beiden Enden im Gehäuse befestig sein. In beiden Fällen ist das Bewegungsübertragungselement im Bereich zwischen dem ersten Ende und dem zweiten Ende der Rückholblattfeder mit dieser fest verbunden. Ist der Aktuator als piezoelektrisches Element ausgeführt, so befindet sich dieses Element bei einseitig im Gehäuse befestigter Rückholblattfeder zwischen dessen im Gehäuse befestigten ersten Ende und dem Bewegungsübertragungselement. In dem Fall, dass die Rückholblattfeder an beiden Enden im Gehäuse befestigt ist, ist zweckmäßigerweise beidseitig des Bewegungsübertragungselements jeweils ein piezoelektrisches Element mit der Rückholblattfeder starr verbunden. In den anderen oben beschriebenen Varianten der Ausgestaltung des Aktuators für das aktive haptische Feedback ist ein Bauteil des Aktuators in demjenigen Bereich der Rückholblattfeder angebracht oder wirkt auf denjenigen Bereich der Rückholblattfeder ein, in dem die Rückholblattfeder mit dem Bewegungsübertragungselement verbunden ist. Die Rückholblattfeder befindet sich also in diesem besagten Bereich zwischen Bewegungsübertragungselement und Aktuator.

Das erfindungsgemäße aktive haptische Feedback kann zweckmäßigerweise auch die Anregung eines Ausgleichsgewichts umfassen, wie es prinzipiell in WO-A-2017/162586 beschrieben ist. Durch die Anregung des Ausgleichsgewichts gegenphasig zur Anregung der Rückholblattfeder ist es möglich, die Bedienvorrichtung sozusagen entkoppelt, d. h. frei von dynamischen Auswirkungen auf die Umgebung auszugestalten, in der die Bedienvorrichtung angeordnet ist. Kraftübertragungen auf die Instrumententafel oder die Mittelkonsole, in bzw. an den die Bedienvorrichtung typischerweise in einem Fahrzeug angeordnet ist, sind damit unterbunden.

In zweckmäßiger Ausgestaltung der Erfindung ist vorgesehen, dass das Bewegungsübertragungselement als Platte ausgebildet ist, die sich von dem Montagerandabschnitt erstreckende, von der Unterseite der Bedienplatte weg gerichtete Seitenrandabschnitte aufweist, die parallel zueinander oder aufeinander zu bis zum unteren Ende des Bewegungsübertragungselements verlaufen. Das Bewegungsübertragungselement sollte sich über eine Länge, die zwischen 1/6 und 1/3 (oder 1/2) der Längserstreckung der Bedienplatte beträgt, erstrecken und über diese Länge fest mit der Unterseite der Bedienplatte direkt oder indirekt verbunden sein. Das gewährt eine zuverlässige Umsetzung der Durchbiegung der Bedienplatte in einen Versatz des Bewegungsübertragungselements orthogonal zur Bedienoberfläche, und zwar unabhängig davon, an welchem Bedienfeld der Bedienplatte gegen diese gedrückt wird.

Die Ausbildung des Bewegungsübertragungselements als Platte und insbesondere als Platte mit zentraler Öffnung, so dass das Bewegungsübertragungselement im Wesentlichen der Form eines Rahmens gleicht, hat den Vorteil der leichtgewichtigen Ausführung des Bewegungsübertragungselements bei steifer und schubstabiler Ausbildung des Bewegungsübertragungselements. In den Rahmen, d.h. durch die zentrale Öffnung, kann zweckmäßigerweise ein Führungsvorsprung o.dgl. -element hineinragen, an dem der Rahmen bei lateraler Bewegung des Bewegungsübertragungselements unterstützend geführt ist.

Der Rahmen weist beispielsweise bei geradlinig verlaufendem oberen Rand insgesamt eine rechteckige Struktur oder eine dreieckige (als gleichschenkliges Dreieck oder als rechtwinkliges Dreieck) Struktur oder eine Trapezform auf, kann sich also zu seinem unteren Rand verjüngen.

Der untere Rand am unteren Ende des Bewegungsübertragungselements ist zweckmäßigerweise parallel zum Montagerandabschnitt des Bewegungsübertragungselements verlaufend ausgebildet.

Statt eines Rahmens oder statt des oberen und unteren Randes des Bewegungsübertragungselements kann dieses auch als ein einzelner, nach unten verlaufender Stab, als T- oder Doppel-T-förmiges Bauteil oder als TT-förmiges Element mit einem oberen Randteil und zwei nach unten verlaufenden Seitenteilen ausgebildet sein.

Wie oben beschrieben, ist die Bedienplatte elastisch ausgebildet oder elastisch gelagert, was direkt oder indirekt erfolgen kann. Von Vorteil ist die elastische Ausbildung der Bedienplatte, was bei einem Material wie beispielsweise Kunststoff, aus dem die Bedienplatte vorteilhafterweise besteht, grundsätzlich materialbedingt gegeben ist. Die Elastizität der Bedienplatte gewährleistet deren Zurückbewegen in die möglichst plane Ruhestellung nach dem Loslassen der Bedienplatte im Anschluss an die Beendigung einer Betätigung, bei der sich die Bedienplatte zwischen ihren beiden Auflageenden (leicht) durchbiegt. Wegen dieser Durchbiegung der Bedienplatte ist das Bewegungsübertragungselement von Vorteil, das unabhängig von der Stelle auf der Bedienplatte, an der die Betätigung durch Drücken gegen diese manuell erfolgt, für eine Art Parallelverschiebung und damit für die zuverlässige Erkennung der Betätigung durch einen die Annäherung des Bewegungsübertragungselements erkennenden Weg- bzw. Abstandssensor oder durch einen Kraftsensor sorgt. Außerdem bedarf es nun nicht mehr mehrerer derartiger Sensoren zur Erkennung einer validen Betätigung der Bedienplatte.

Dieses Zurückbewegen der Bedienplatte in die Ausgangs- oder Ruhestellung kann zweckmäßigerweise durch eine zusätzliche Rückholfeder unterstützt werden, die entweder direkt an der Bedienplatte angreift oder aber indirekt mit dieser zusammenwirkt, indem sie beispielsweise an dem Bewegungsübertragungselement angreift. Im letztgenannten Fall ist es von Vorteil, wenn die Rückholfeder als eine Blattfeder ausgebildet ist, die zumindest an einer der beiden jeweils zu einem Auflageende der Bedienplatte weisenden Seiten des Bewegungsübertragungselements von diesem absteht und ein dem Bewegungsübertragungselement abgewandtes Montageende aufweist, an dem die Blattfeder an dem Gehäuse befestigt ist. Die Blattfeder ist an ihrem Montageende am Gehäuse befestigt, wobei das Bewegungsübertragungselements und die Blattfeder änderungsfrei an dem oder in dem Gehäuse bewegbar sind.

Von Vorteil ist es, wenn die Platte des Bewegungsübertragungselements und die Blattfeder einteilig ausgebildet sind und Metall, insbesondere Stahl und vorzugsweise Federstahl aufweisen (oder aus diesem bestehen), wobei die Platte am unteren Rand umgebogen ist und sich an diesen umgebogenen unteren Rand ein Mittelteil der Blattfeder anschließt, von dem aus sich zu einer oder zu beiden zu jeweils einem Auflageende der Bedienplatte weisenden Seiten ein oder jeweils ein Blattfederarm erstreckt. Der Mittelteil der Blattfeder bildet also deren Lagerung (Fixierung) am Bewegungsübertragungselement, während das oder die Montageenden des oder der Blattfederarme deren Lagerung an dem Gehäuse bilden. Die Blattfeder gemäß dieser Ausgestaltung erstreckt sich also zu einer Seite oder zu beiden einander abgewandten Seiten des Bewegungsübertragungselements und parallel zur Längserstreckung der Bedienplatte. Wird gegen die Bedienplatte gedrückt, so verformen sich die Blattfederarme elastisch in Versatzbewegungsrichtung des Bewegungsübertragungselements. Vorteilhaft ist es, wenn das Bewegungsübertragungselements und die Blattfeder bzw. die Blattfederarme ein gemeinsames Bauteil bilden. Das Bewegungsübertragungselements ist im Wesentlichen orthogonal zur Bedienplatte ausgerichtet, während die Blattfeder wiederum orthogonal dazu wirkt, was bedeutet, dass die Platte oder der Rahmen des Bewegungsübertragungselements an seinem unteren Ende umgebogen ist und dieser Teil den Mittelteil der Blattfeder bildet, von der aus sich beidseitig dann jeweils ein Blattfederarm erstreckt mit jeweils einem Montageende an seinem freien Ende.

Der Montagerandabschnitt des Bewegungsübertragungselements ist zweckmäßigerweise über ein Montageelement mit der Unterseite der Bedienplatte verbunden.

In weiterer zweckmäßiger Ausgestaltung der Erfindung kann vorgesehen sein, dass die Aussparung an der Vorderseite des Gehäuses einen die beiden Auflagerandabschnitte des Gehäuses verbindenden Lateralrandabschnitt aufweist, an dem ein erster Lateralrandabschnitt der Bedienplatte aufliegt oder aufliegend befestigt ist, und dass das Bewegungsübertragungselement an einem dem ersten Lateralrandabschnitt der Bedienplatte gegenüberliegenden zweiten Lateralrandabschnitt der Bedienplatte montiert ist, wobei unterhalb dieses zweiten Lateralrandabschnitts der Bedienplatte bis zur Aussparung des Gehäuses ein Bewegungsspalt angeordnet ist. Durch die insbesondere Klebeverbindung der Bedienplatte mit dem Gehäuse nicht nur an ihren Auflageenden, sondern auch an einem ihrer Lateralabschnitte, ist die Durchbiegungsbewegungsfreiheit der Bedienplatte an der Vorderseite des Gehäuses beeinträchtigt. Wenn man nun dafür sorgt, dass der zweite Lateralrandabschnitt der Bedienplatte nicht oder zumindest nicht starr mit dem Gehäuse verbunden ist, sondern wenn man dafür sorgt, dass sich unterhalb dieses weiteren Lateralrandabschnitts der Bedienplatte zum Gehäuse hin ein Bewegungsspalt befindet, der erforderlichenfalls mit einer (hoch-)elastischen komprimierbaren Dichtung verschlossen ist, so lässt sich die Bedienplatte weiterhin noch ausreichend frei in ihrer Bewegung durchbiegen, wenn gegen die Bedienplatte an einem Bedienfeld gedrückt wird. Der Bewegungsspalt in zumindest einem Teilbereich dieses zweiten Lateralrandabschnitts der Bedienplatte weist in der Einbausituation der Bedienvorrichtung typischerweise nach unten, wenn die Bedienvorrichtung, wie typischerweise vorgesehen, an einer vertikal oder im Wesentlichen vertikal verlaufenden Fläche der Instrumententafel eines Fahrzeugs angeordnet ist. Somit kann verhindert werden, dass über den Bewegungsspalt versehentlich Flüssigkeit ins Innere der Bedienvorrichtung gelangt.

Sofern die Bedienplatte insbesondere breitere Ausmaße aufweist, beispielsweise auf ihrer Bedienoberfläche mehrere Zeilen von nebeneinanderliegenden Bedienfeldern aufweist, kann mit Vorteil auch vorgesehen sein, an beiden zuvor genannten Lateralrandabschnitten jeweils ein Bewegungsübertragungselement vorzusehen.

Innerhalb des zweiten Lateralrandabschnitts der Bedienplatte kann an dieser zweckmäßigerweise das Bewegungsübertragungselement angekoppelt sein, womit sich dieses Bewegungsübertragungselement entweder innerhalb des Gehäuses oder außen mit geringem Abstand zum Gehäuse bewegen kann.

Diese zuvor genannten Konstruktion führt zu einer platzsparenden Bauform.

Wie bereits oben beschrieben, weist die Bedienplatte eine Berührungssensorik auf, über die erkannt wird, welches Bedienfeld beim Niederdrücken der Bedienplatte berührt wird. Die Bedienfelder sind mit alphanumerischen Zeichen oder Symbolen versehen, die zweckmäßigerweise hinterleuchtbar sind. Hierzu dient gemäß einer insoweit vorteilhaften Ausgestaltung der Erfindung, dass die Aussparung an der Vorderseite des Gehäuses einen Boden aufweist, in dem Lichtaustrittsöffnungen oder transparente Bereiche für Hinterleuchtungslicht zum Hinterleuchten der Bedienfelder der Bedienplatte ausgebildet sind, und dass in dem Gehäuse mindestens eine Hinterleuchtungslichtquelle für Hinterleuchtungslicht angeordnet ist. Das Hinterleuchtungslicht kann alternativ von einer einzigen oder von mehreren Hinterleuchtungslichtquellen stammen und über Lichtleiter zu den Bedienfeldern bzw. nahe zu den Bedienfeldern geführt sein. Auch können im Gehäuse Lichtschächte oder Reflektoren vorgesehen sein, die der Hinterleuchtung der Bedienfelder dienen. Das Gehäuse benötigt hierzu an seiner Vorderseite Lichtdurchlassöffnungen oder Bereiche, die für das Hinterleuchtungslicht transparent sind.

In weiterer vorteilhafter Ausgestaltung der Erfindung kann vorgesehen sein, dass der Betätigungssensor ein Weg- oder Kraftsensor oder ein für mechanische Beanspruchungen empfindlicher Sensor ist. Insbesondere ist es zweckmäßig, wenn der Betätigungssensor als ein optischer Wegsensor zur Erfassung einer bei einer Durchbiegung der Bedienplatte erfolgenden Änderung des Abstandes des unteren Endes des Bewegungsübertragungselements zu dem Gehäuse ausgebildet ist.

In vorteilhafter Ausgestaltung der Erfindung kann vorgesehen sein, dass dasmindestens eine Bewegungsübertragungselement als Platte ausgebildet ist, die sich von dem Montagerandabschnitt erstreckende, von der Unterseite der Bedienplatte weg gerichtete Seitenrandabschnitte aufweist, die parallel zueinander oder aufeinander zu bis zum unteren Ende des mindestens einen Bewegungsübertragungselements verlaufen.

Zweckmäßig kann es sein, wenn das untere Ende des mindestens einen Bewegungsübertragungselements einen zum Montagerandabschnitt parallelen Randabschnitt aufweist.

Ferner kann es von Vorteil sein, wenn die Platte des mindestens einen Bewegungsübertragungselements eine Öffnung aufweist und dass der Montagerandabschnitt, die Seitenrandabschnitte und das untere Ende des mindestens einen Bewegungsübertragungselements einen Rahmen bilden.

Zweckmäßigerweise wirkt die Rückholfeder zur Unterstützung der Zurückbewegung der Bedienplatte nach einem manuellen Niederdrücken derselben direkt oder indirekt mit der Bedienplatte zusammen.

Vorteilhaft kann es ferner sein, dass die Rückholfeder als eine Blattfeder ausgebildet ist, die zumindest an einer der beiden jeweils zu einem Auflageende der Bedienplatte weisenden Seiten des mindestens einen Bewegungsübertragungselements von diesem absteht und ein dem mindestens einen Bewegungsübertragungselement abgewandtes Montageende aufweist, an dem die Blattfeder an dem Gehäuse befestigt ist.

Die Blattfeder kann beidseitig des mindestens einen Bewegungsübertragungselements jeweils zu einem Auflageende der Bedienplatte weisend übersteht und zwei an dem Gehäuse befestigte zu den Auflageelementen jeweils höhenversetzte angeordnete Montageenden aufweisen.

In zweckmäßiger Ausgestaltung der Erfindung ist es von Vorteil, dass die Platte des mindestens einen Bewegungsübertragungselements und die Blattfeder einteilig ausgebildet sind und Metall, insbesondere Stahl und vorzugsweise Federstahl aufweisen, wobei die Platte am unteren Rand umgebogen ist und sich an diesen umgebogenen unteren Rand ein Mittelteil der Blattfeder anschließt, von dem aus sich zu einer oder zu beiden zu jeweils einem Montageende des Gehäuses weisenden Seiten ein oder jeweils ein Blattfederarm erstreckt.

Die Aussparung an der Vorderseite des Gehäuses kann einen die beiden Auflagerandabschnitte des Gehäuses verbindenden Lateralrandabschnitt aufweisen, an dem ein erster Lateralrandabschnitt der Bedienplatte aufliegt oder aufliegend befestigt ist, wobei das Bewegungsübertragungselement an einem dem ersten Lateralrandabschnitt der Bedienplatte gegenüberliegenden zweiten Lateralrandabschnitt der Bedienplatte montiert ist und wobei unterhalb dieses zweiten Lateralrandabschnitts der Bedienplatte bis zur Aussparung des Gehäuses ein Bewegungsspalt angeordnet ist.

In zweckmäßiger weiterer Ausgestaltung der Erfindung kann vorgesehen sein, dass die Aussparung an der Vorderseite des Gehäuses einen Boden aufweist, in dem Lichtaustrittsöffnungen oder transparente Bereiche für Hinterleuchtungslicht zum Hinterleuchten der Bedienfelder der Bedienplatte ausgebildet sind, und dass in dem Gehäuse mindestens eine Hinterleuchtungslichtquelle für Hinterleuchtungslicht angeordnet ist.

Der Betätigungssensor ist zweckmäßigerweise als ein Weg- oder Kraftsensor oder ein für mechanische Beanspruchungen empfindlicher Sensor ausgebildet. Der Betätigungssensor kann als ein optischer Wegsensor zur Erfassung einer bei einer Durchbiegung der Bedienplatte erfolgenden Änderung des Abstandes des unteren Endes des mindestens einen Bewegungsübertragungselements zu dem Gehäuse und insbesondere zur Unterseite des Gehäuses ausgebildet sein.

Zweckmäßig kann es ferner sein, wenn der Montagerandabschnitt des mindestens einen Bewegungsübertragungselements eine Länge aufweist, die zwischen 1/6 und 1/3 der Längserstreckung der Bedienplatte zwischen deren Auflageenden beträgt und/oder wenn der Montagerandabschnitt des mindestens einen Bewegungsübertragungselements symmetrisch zur Mitte der Bedienplatte zwischen deren Auflageenden angeordnet ist.

Vorteilhaft ist es ferner, wenn die Bedienplatte ein für Hinterleuchtungslicht transparentes Material, wie z.B. Glas oder Kunststoff aufweist.

Schließlich ist es möglich, dass die Bedienplatte streifenförmig ausgebildet ist und dass die Bedienfelder an der Oberseite der Bedienplatte in deren Längserstreckung nebeneinander aufeinanderfolgend angeordnet sind.

Die Erfindung wird nachfolgend anhand mehrerer Ausführungsbeispiele und unter Bezugnahme auf die Zeichnung näher erläutert. Im Einzelnen zeigen dabei:
- Fig. 1: eine Ansicht auf die Instrumententafel eines Fahrzeugs mit angedeuteter Positionierung eines Ausführungsbeispiels der erfindungsgemäßen Bedienvorrichtung,
- Fig. 2: eine Explosionsdarstellung der einzelnen Komponenten der Bedienvorrichtung,
- Fig. 3: eine schematische Darstellung des Wirkprinzips bei der Bedienung einzelner Bedienfelder der Bedienvorrichtung,
- Fig. 4: eine Seitenansicht auf die Bedienvorrichtung,
- Fig. 5: eine perspektivische Unter-/Seitenansicht der Bedienvorrichtung,
- Fig. 6: eine Ansicht auf die Bedienvorrichtung perspektivisch und im Schnitt,
- Fig. 7: eine Ansicht auf ein Bauteil mit zwei Bewegungsübertragungselementen und integral mit diesen verbundener Blattfeder,
- Fig. 8: die Einbausituation für das in Fig. 7 gezeigte Bauteil mit Bewegungsübertragungselementen,
- Fig. 9: schematisch die Konstruktion der beiden Ausführungsbeispiele der Bedienvorrichtung mit einer ersten Variante eines Aktuators für das aktive haptische Feedback,
- Fig. 10: schematisch die Konstruktion der beiden Ausführungsbeispiele der Bedienvorrichtung mit einer zweiten Variante eines Aktuators für das aktive haptische Feedback,
- Fig. 11: schematisch die Konstruktion der beiden Ausführungsbeispiele der Bedienvorrichtung mit einer dritten Variante eines Aktuators für das aktive haptische Feedback,
- Fig. 12: schematisch die Konstruktion der beiden Ausführungsbeispiele der Bedienvorrichtung mit einer vierten Variante eines Aktuators für das aktive haptische Feedback,
- Fign. 13 bis 15: schematisch die Konstruktion der beiden Ausführungsbeispiele der Bedienvorrichtung mit einer fünften Variante eines Aktuators für das aktive haptische Feedback,
- Fig. 16: schematisch die Konstruktion der beiden Ausführungsbeispiele der Bedienvorrichtung mit einer sechsten Variante eines Aktuators für das aktive haptische Feedback,
- Fig. 17.: schematisch die Konstruktion der beiden Ausführungsbeispiele der Bedienvorrichtung mit einer siebten Variante eines Aktuators für das aktive haptische Feedback und
- Fign. 18 und 19: Schematisch die Konstruktion und das Blockschaltbild eines rückgekoppelten Ansteuerungssystems für das aktive haptische Feedback

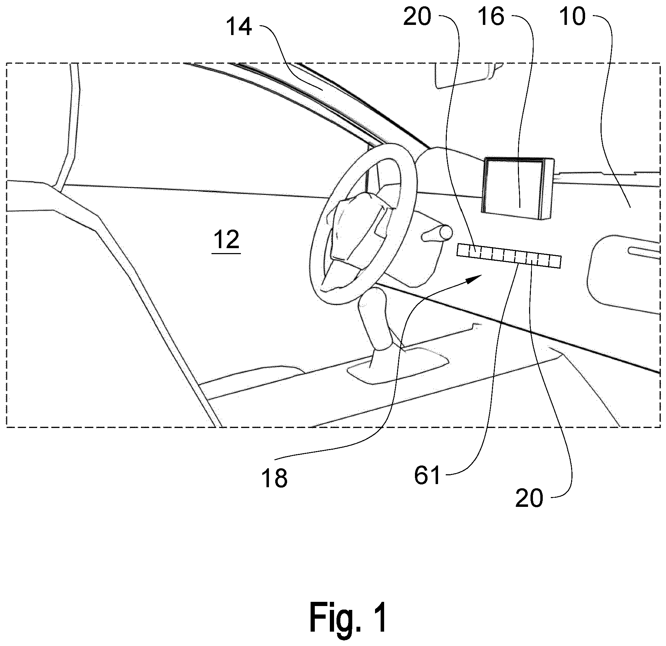

Fig. 1 zeigt eine perspektivische Ansicht auf die Instrumententafel 10 im Innenraum 12 eines Fahrzeugs 14, die in diesem Ausführungsbeispiel mit einem Display 16 und einem Ausführungsbeispiel einer erfindungsgemäßen Bedienvorrichtung 18 versehen ist, bei der es sich um eine Bedienleiste mit geschlossener Oberfläche und mehreren in Fig. 1 durch gestrichelte Linien angedeuteten Bedienfeldern 20 (in diesem Fall fünf derartige Bedienfelder) handelt. Das Besondere an der Bedienvorrichtung 18 ist in der Tatsache zu sehen, dass die Bedienoberfläche von einer flexiblen, elastischen, streifenförmigen Bedienplatte 24 gebildet wird, die bei Kontakt an einem beliebigen der Bedienfelder 20 niederdrückbar ist und sich leicht durchbiegt, wobei ein einziger Sensor ausreichend ist, um eine valide Betätigung der Bedienvorrichtung 18 zu erkennen.

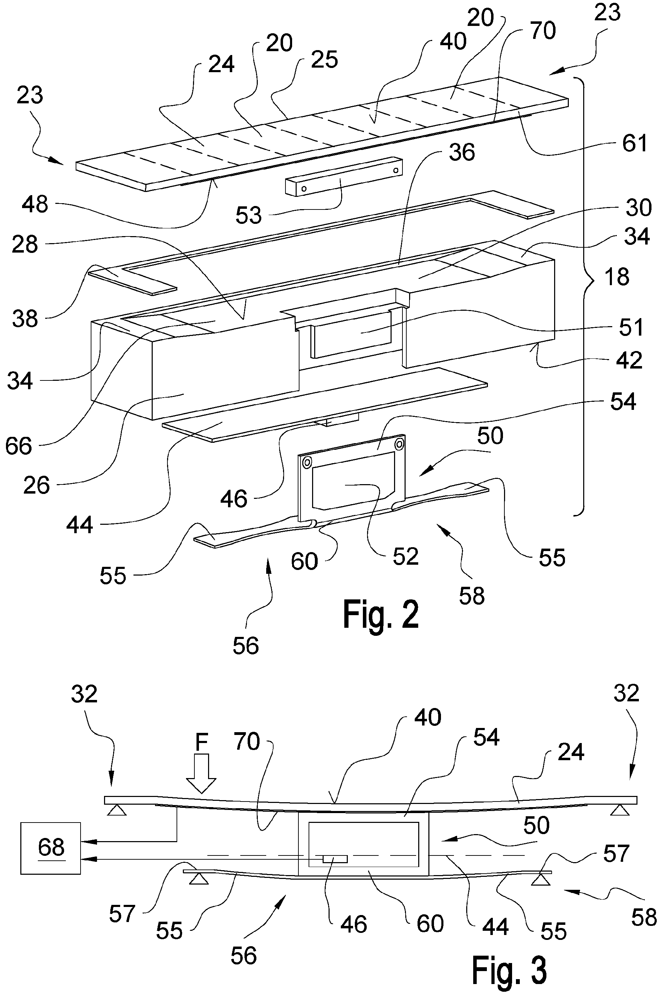

Der Aufbau der Bedienvorrichtung 18 ist in den Fign. 2 bis 6 gezeigt.

Die Bedienvorrichtung 18 weist, wie bereits oben erwähnt, eine längliche, streifenförmige Bedienplatte 24 auf, auf der, was in den Figuren nicht gezeigt ist, typischerweise alphanumerische Zeichen oder Symbole zur Kennzeichnung der durch die einzelnen Bedienfelder auszulösenden Funktionen wiedergegeben sind. Die flexible Bedienplatte 24 aus beispielsweise Kunststoff liegt an in Längserstreckung einander abgewandten Auflageenden 23 sowie an einem ihrer Längsrandabschnitte 25 auf einem Gehäuse 26 auf, das eine Vorderseite 28 aufweist. An der Vorderseite 28 befindet sich am Gehäuse 26 eine vergleichsweise flache Mulde oder Vertiefung oder allgemein Aussparung 30, die an den beiden gegenüberliegenden Schmalrändern 32 der Vorderseite 28 Auflagerandabschnitte 34 aufweist. Längs einer Lateralseite des Gehäuses 26 an deren Vorderseite befindet sich ein Lateralrandabschnitt 36. Die diesem Lateralrandabschnitt 36 gegenüberliegende Lateralseite weist einen derartigen aufragenden Randabschnitt nicht auf, so dass die Aussparung 30 insoweit zu dieser Lateralseite hin offen ist und z.B. durch ein komprimierbares Dichtungsband vor dem Eindringen von z.B. Staubpartikeln geschützt sein kann.

Auf den beiden zuvor genannten Auflagerandabschnitten 34 und dem Lateralrandabschnitt 36 liegt ein doppelseitig klebendes Fixierband 38 auf, das sozusagen C-förmig ausgebildet ist. Auf diesem Fixierband 38 schließlich liegt die Bedienplatte 24 auf, die auf diese Weise an drei Seiten bzw. Rändern nämlich an den Rändern der Auflageenden 23 und an dem einen der beiden Längsrandabschnitte 25 mit dem Gehäuse 26 an dessen Vorderseite 28 fest verbunden ist. Durch die Aussparung 30 unterhalb der Bedienplatte 24 kann sich diese nun geringfügig durchbiegen, wenn auf die Oberseite der Bedienplatte 24, die die Bedienoberfläche 40 bildet, Druck ausgeübt wird. Die Klebeverbindung von Bedienplatte 24 und Gehäuse 26 kann aber auch nur an den Auflageenden 23 und den Auflagerandabschnitten 34 vorgesehen sein.

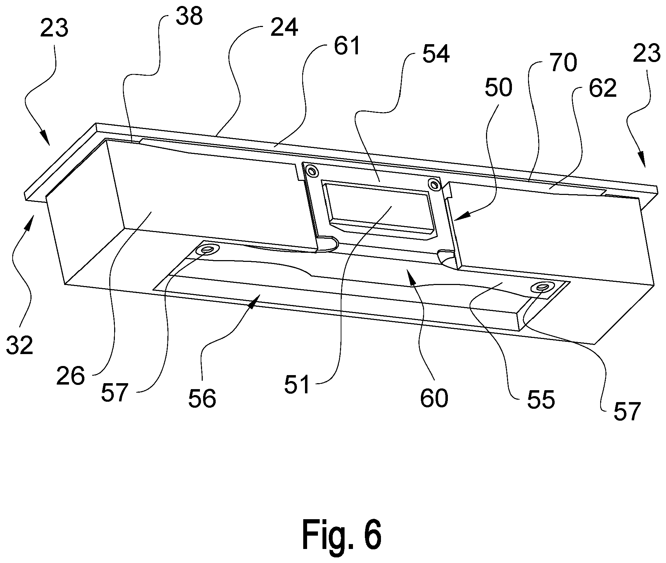

An der Unterseite 42 des Gehäuses 26 befindet sich eine Trägerplatte 44 für diverse elektrische und elektronische sowie optische Bauteile wie beispielsweise Hinterleuchtungslichtquellen, wie in Fig. 6 gezeigt. Außerdem befindet sich auf der Trägerplatte 44 ein Betätigungssensor 46, der eine Betätigung (Durchbiegung) der Bedienplatte 24 erkennt.

Um nun unabhängig davon, an welchem der Bedienfelder 20 die Bedienplatte 24 gedrückt wird, die für eine valide Betätigung erforderliche Mindestdurchbiegung erkennen zu können, ist mit der Unterseite 48 der Bedienplatte 24 ein Bewegungsübertragungselement 50 mechanisch verbunden, das sich orthogonal zur Unterseite 48 der Bedienplatte 24 von dieser weg erstreckt. Dieses Bewegungsübertragungselement 50 ist in diesem Ausführungsbeispiel als Metallrahmen 49 ausgebildet, weist also eine Platte mit einer Öffnung 52 auf. Der obere Montagerandabschnitt 54 des Bewegungsübertragungselements 50 ist geradlinig ausgebildet und verläuft in Längserstreckungsrichtung der Bedienplatte 24. Über ein Montageelement 53, das Teil des Montagerandabschnitts 54 ist, ist dieses an der Unterseite 48 der Bedienplatte 24 fest montiert. Durch die Öffnung 52 in der Platte des Bewegungsübertragungselements 50 entsteht der Rahmen 49, in den sozusagen als Linearführungsunterstützung für das Bewegungsübertragungselement 50 beim Verschieben desselben ein Führungsvorsprung 51 vorsteht.

Wie in Fig. 2 zu erkennen ist, erstreckt sich unterhalb des Bewegungsübertragungselements 50 eine in diesem Ausführungsbeispiel zweiarmige Blattfeder 56 als ein Ausführungsbeispiel einer Rückholfeder 58, die die Zurückbewegung der elastischen Bedienplatte 24 nach einem Niederdrücken und nach Aufhebung der Niederdrückkraft wieder in die Ausgangsposition zurückbewegt. Die Rückholfeder 58 ist am unteren Ende 60 des Bewegungsübertragungselements 50 angeordnet und vorzugsweise einteilig mit dem Metallrahmen des Bewegungsübertragungselements 50 verbunden, so dass die Blattfeder 56 und das Bewegungsübertragungselement 50 als ein einteiliges Stanzteil ausgebildet sind, das nach dem Stanzvorgang durch Biegen entlang dem unteren Ende 60 seine in Fig. 2 gezeigte Form erhält.

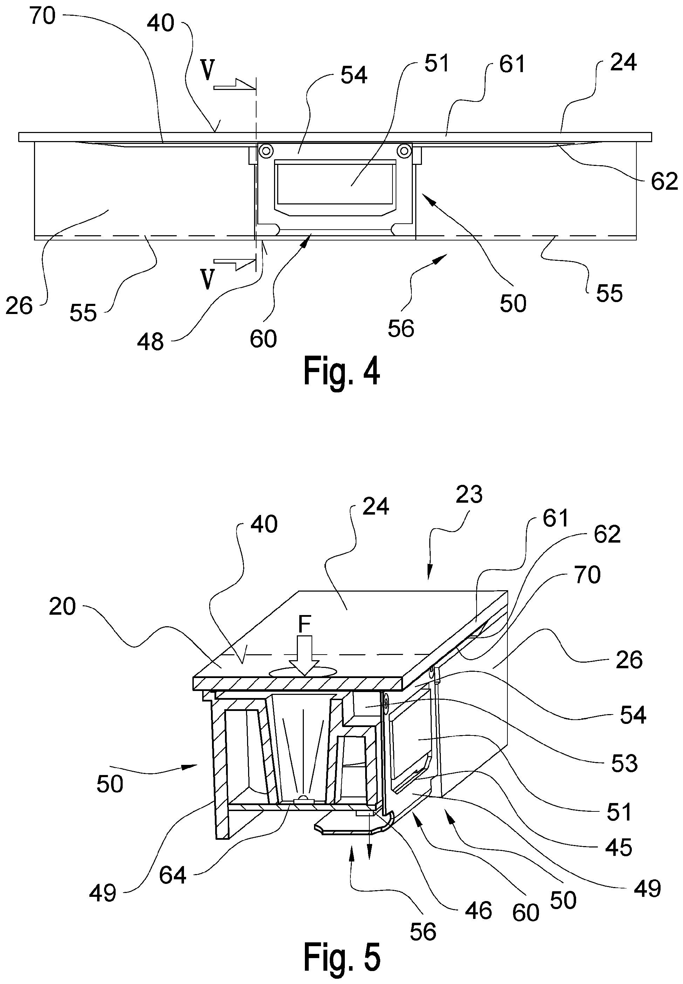

Eine Seitenansicht auf die Bedienvorrichtung 18 mit Ansicht auf das Bewegungsübertragungselement 50 ist in Fig. 4 gezeigt. Wie auch anhand der Fign. 2, 5 und 6 zu erkennen ist, befindet sich das Bewegungsübertragungselement 50 unterhalb desjenigen Längsrandabschnitts 61 der Bedienplatte 24, unterhalb dessen an der Vorderseite 28 des Gehäuses 26 kein Lateralrandabschnitt verläuft, so dass sich dort also ein Bewegungsspalt 62 zwischen der Bedienplatte und der Aussparung 30 an der Vorderseite 28 des Gehäuses 26 bildet.

Die Kinematik der Bedienvorrichtung 18 ist in Fig. 3 gezeigt. Die Blattfeder 56 und die Bedienplatte 24 sind an ihren jeweiligen gegenüberliegenden Enden an Festlagern (in Fig. 3 durch die Dreiecke angedeutet) gelagert. Die beiden (Montage-)Enden 57 der beiden Arme 55 der Blattfeder 56 sind, wie beispielsweise anhand von Fig. 5 zu erkennen ist, an der Unterseite 42 des Gehäuses 26 befestigt, womit sich die beiden in Fig. 3 unteren Lager bilden. Die Bedienplatte 24 ist an ihren Auflageenden 23 am in Fig. 3 nicht gezeigten Gehäuse aufliegend gelagert, womit die in Fig. 3 beiden oberen Lager gebildet sind.

Wird nun wie in Fig. 3 anhand des Pfeils F gezeigt, auf die Bedienoberfläche 40 der Bedienplatte 24 eine Andrückkraft ausgeübt, so bewegt sich die Bedienplatte 24 nach unten und biegt sich dabei durch. Diese Durchbiegung wird im Bereich des Bewegungsübertragungselements 50, das sich vorzugsweise symmetrisch zur Mittellinie der Bedienplatte 24 zwischen deren Auflageenden 23 erstreckt, nach unten übertragen, womit sich die Blattfeder 56 bzw. allgemein die Rückholfeder 58 spannt. Beim Loslassen/Aufheben der Andrückkraft bewegen sich dann Rückholfeder 58 und Bedienplatte 24 wieder zurück in ihre Ausgangspositionen.

Der Vorteil diese Konstruktion, d. h. der Vorteil der Anordnung und Konstruktion des Bewegungsübertragungselements 50 besteht darin, dass sich dieses zuverlässig und in Wesentlichen gleichbleibend nach unten bewegt, wenn an einer beliebigen Stelle der Bedienplatte 24 gegen diese gedrückt wird. Über den Betätigungssensor 46, der beispielsweise als optischer Abstandssensor ausgeführt ist, lässt sich der Bewegungsversatz des Bewegungsübertragungselements 50 erfassen, den dieses beim Drücken gegen die Bedienplatte 24 erfährt. Hierzu ist der Betätigungssensor 46 beispielsweise auf der Trägerplatte 44 angeordnet und "blickt" von dort auf den umgebogenen mittleren Abschnitt des unteren Endes 60 des Bewegungsübertragungselements 50 (siehe Fig. 6). Durch den Pfeil in Fig. 6 ist angedeutet, dass sich das untere Ende 60 des Bewegungsübertragungselements 50 nach unten bewegt, wenn, wie durch den weiteren Pfeil F in Fig. 6 angedeutet, von oben auf die Bedienplatte 24 Druck ausgeübt wird. Da die Position des Betätigungssensors 46 relativ zum Gehäuse 26 unverändert bleibt, kann eine Abstandsveränderung also beispielsweise optisch, kapazitiv, induktiv o.dgl. erkannt werden.

In Fig. 6 ist überdies noch angedeutet, dass innerhalb des Gehäuses, nämlich auf der Trägerplatte 44 ein oder mehrere Hinterleuchtungslichtquellen 64 angeordnet sind, deren Licht beispielsweise durch Lichtleiter oder Reflektoren von unten gegen die Unterseite 48 der Bedienplatte 24 gerichtet ist, wobei der Boden 66 der Aussparung 30 des Gehäuses 26 für das Licht transparente Zonen oder gar Öffnungen aufweist, damit das Hinterleuchtungslicht aus dem Gehäuse 26 heraus und von unten gegen die Bedienplatte 24 gelangt, wo die Symbole oder alphanumerischen Zeichen der Bedienfelder 20 hinterleuchtet werden. Zu diesem Zweck kann die Unterseite 48 der Bedienplatte 24 eine lichtundurchlässige Beschichtung aufweisen, die frei geschnittene, typischerweise durch Laser frei geschnittene Symbole oder alphanumerische Zeichen aufweist, die dann durch die Hinterleuchtung deutlicher sichtbar werden.

Für die Auswertung dahingehend, ob eine manuelle Betätigung der Bedienplatte 24 eine gültige Befehlseingabe bedeutet, dient eine Ansteuer- und Auswerteeinheit 68, die schematisch in Fig. 3 angedeutet ist. Diese Ansteuer- und Auswerteeinheit 68, die elektronisch arbeitet und beispielsweise I/o-Ports, Speicher und einen Mikroprozessor aufweist, erhält Signale vom Betätigungssensor 46 sowie von einer Berührungssensorik 70 an beispielsweise der Unterseite der Bedienplatte 24. Diese Berührungssensorik kann kapazitiv, resistiv, optisch o.dgl. arbeiten. Durch die Berührungssensorik 70 wird also die Position erkannt, an der auf der Bedienoberfläche 40 der Bedienplatte 24 gegen diese gedrückt wird. Der Betätigungssensor 46 gibt ein Messignal aus, das repräsentativ ist für die Veränderung seines Abstandes zum Montageende 60 des Bewegungsübertragungselements 50. Ist eine vorgegebene Mindestabstandsänderung erreicht, so wird eine gültige/valide manuelle Bedienung der Bedienoberfläche 40 der Bedienvorrichtung 18 erkannt, um dann die Aktion auszulösen, die dem berührten Bedienfeld 20 der Bedienplatte 24 zugeordnet ist.

Wie weiter oben beschrieben ist, befindet sich unterhalb des Längsrandabschnittes 61 der Bedienplatte 24 der Bewegungsspalt 62. Wird die Bedienvorrichtung 18, wie in Fig. 1 gezeigt, dergestalt ausgerichtet, dass sich dieser Bewegungsspalt 62 am im Einbauzustand unteren Rand der Bedienvorrichtung 18 befindet, so wird also weiterhin zuverlässig das Eindringen von beispielsweise Flüssigkeiten in die Bedienvorrichtung 18 verhindert. Hierzu trägt vor allem auch die geschlossene Bedienoberfläche 40 bei.

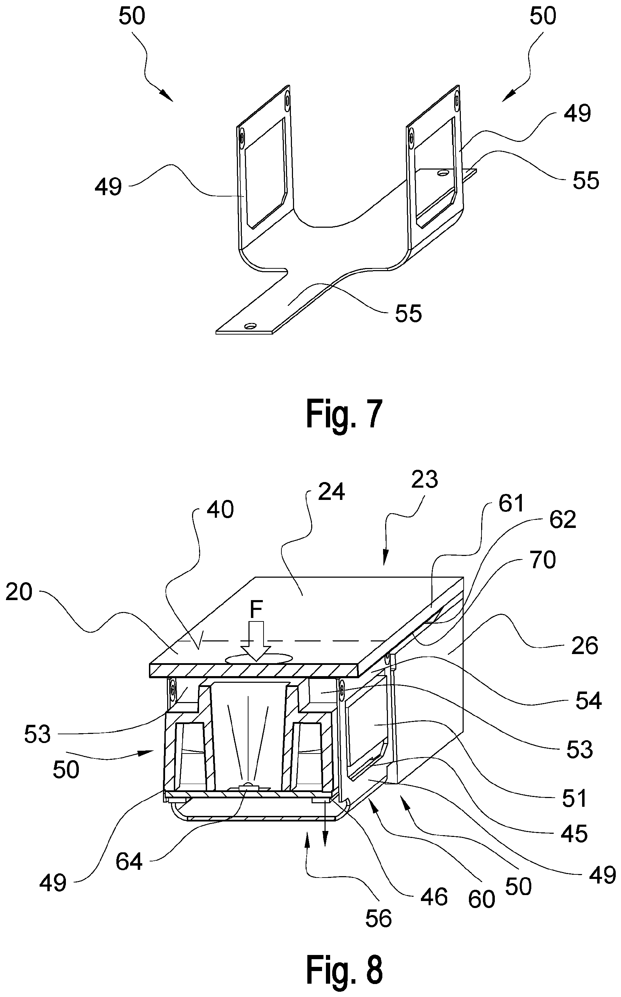

Die bisherige Beschreibung des Ausführungsbeispiels der Erfindung betrifft die Verwendung eines Bewegungsübertragungselements 50. Wie bereits weiter oben beschrieben, kann es je nach Größe der Bedienplatte 24 der Bedienvorrichtung 18 von Vorteil sein, wenn zwei Bewegungsübertragungselemente 50 vorgesehen sind. Das diesbezüglich einsetzbare Metall-Bauteil mit zwei jeweils als Rahmen 49 ausgebildeten Bewegungsübertragungselementen 50 und der integral mit beiden verbundenen Blattfeder 56 ist in Fig. 7 gezeigt.

Die Einbausituation dieses Bauteils ist in Fig. 8 gezeigt. Die muldenförmige Aussparung 30 an der Vorderseite 28 des Gehäuses 26 weist nun an ihren beiden parallel verlaufenden Lateralrandabschnitten 36 einen Bewegungsspalt 62 auf. An beiden Längsseitenflächen des Gehäuses 26 befindet sich jeweils ein Führungsvorsprung 51. Die beiden Rahmen 49 sind jeweils mit einem Montageelement 53 an der Unterseite 42 der Bedienplatte 24 verbunden.

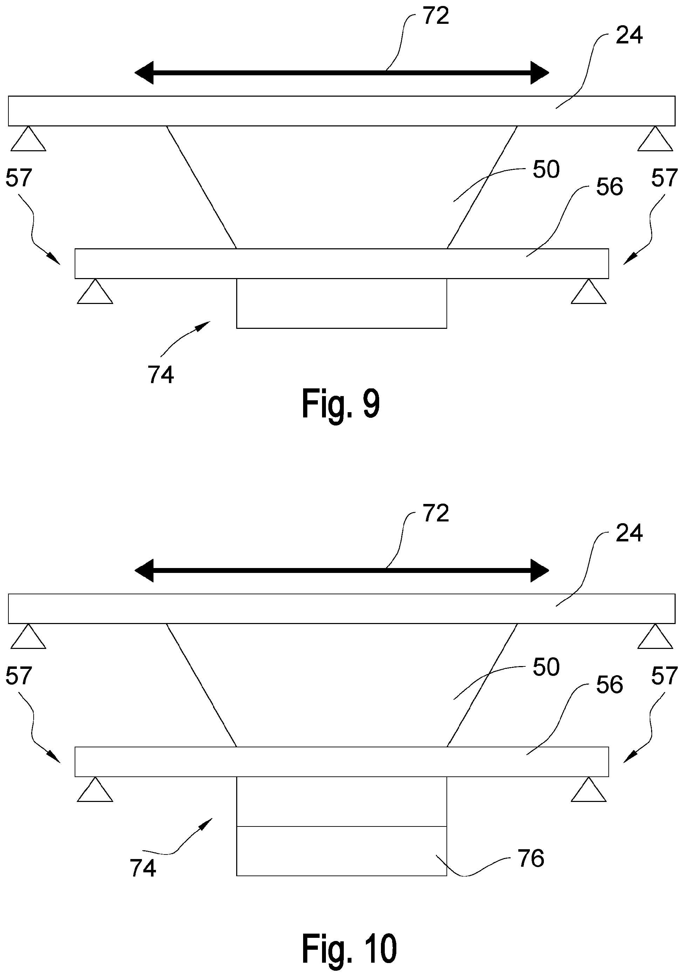

In den Fign. 9 bis 18 ist der Aufbau der zuvor beschriebenen Bedienvorrichtung 18 insoweit stark schematisiert gezeigt, als lediglich noch die Elemente wiedergegeben sind, die für das erfindungsgemäße aktive haptische Feedback ausschlagegebend sind.

In Fig. 9 ist mit dem Doppelpfeil 72 der Bereich der Bedienfelder 20 auf der Bedienplatte 24 angedeutet. Das Bewegungsübertragungselement 50 ist durch das trapezförmige Element repräsentiert und verbindet die Bedienplatte 24 mit der Rückholblattfeder 56. Die Rückholblattfeder 56 ist an ihren beiden Montageenden 57 im Gehäuse gelagert.

An der Rückholblattfeder 56 angebracht oder mit dieser in Wirkverbindung stehend ist ein Aktuator 74, der optional (siehe Fig. 10) im Gehäuse abgestützt ist (siehe in Fig. 10 bei 76 angedeutet).

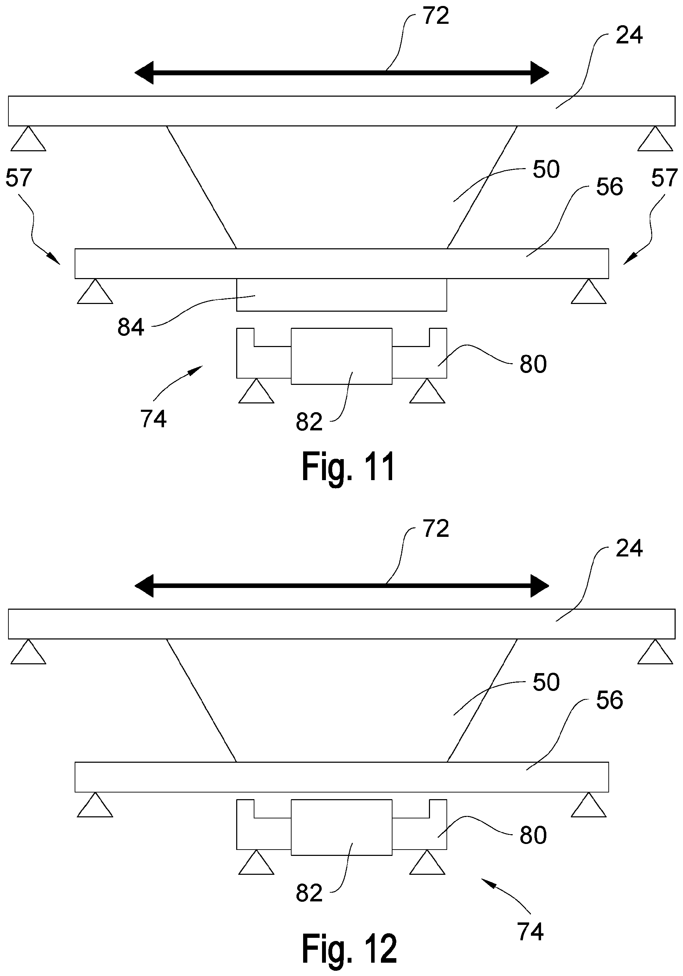

In den Fign. 11 und 12 sind zwei Ausführungsbeispiele als zwei Varianten des Aktuators 74 gezeigt, in denen der Aktuator 74 als Zugankermagnet 78 (oder auch Zugankerelektromagnet) ausgebildet ist. Beim Ausführungsbeispiel der Fig. 11 weist der Zugankermagnet 78 einen Stator 80 mit einer Statorspule 82 und einem ferromagnetischen Anker 84 auf. Der Anker 84 ist mit der Rückholblattfeder 56 verbunden, und zwar vorzugsweise an deren Unterseite in demjenigen (insbesondere Mitten-) Bereich, in dem das Bewegungsübertragungselement 50 an der Oberseite der Rückholblattfeder 56 mit dieser verbunden ist. Der Stator 80 ist im Gehäuse gelagert. In dem Ausführungsbeispiel nach Fig. 12 wird der Anker des Zugankermagneten 78 von der Blattfeder 56 selbst gebildet, die zu diesem Zweck ferromagnetische Eigenschaften aufweist.

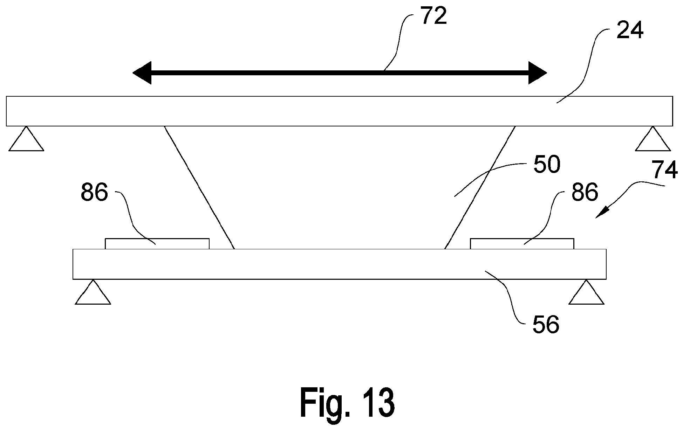

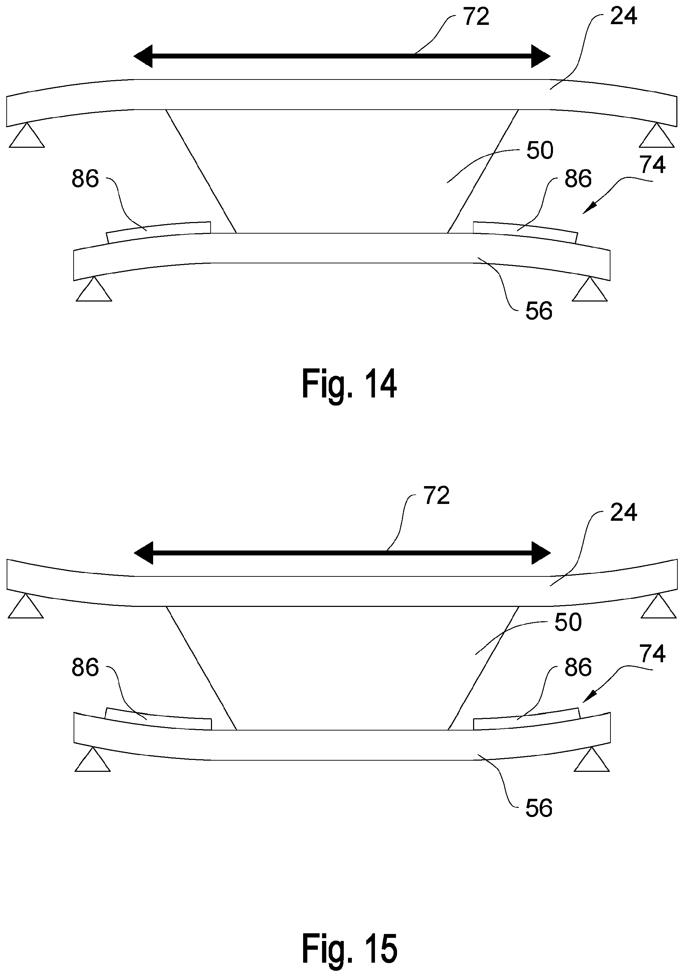

Im Ausführungsbeispiel der Fign. 13 bis 15 werden als Aktuator 74 zwei piezoelektrische Elemente 86 verwendet, die beidseitig der Verbindung von Bewegungsübertragungselement 50 und Rückholblattfeder 56 an der Rückholblattfeder 56 schubsteif befestigt sind. Die Fign. 14 und 15 zeigen, wie sich die Bedienplatte 24 und die Rückholblattfeder 56 je nach Polung der elektrischen Spannung an den piezoelektrischen Elementen bewegen/verformen.

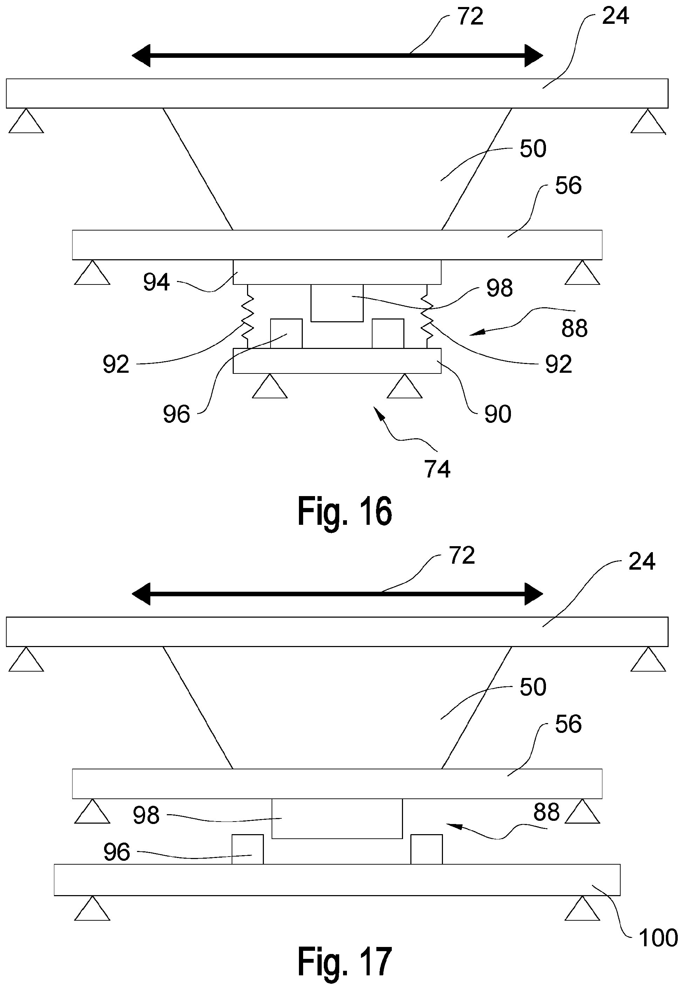

In der Fig. 16 ist der Aktuator 74 als Tauchspulenaktuator 88 ausgebildet. Der Tauschspulenaktuator 88 weist eine Grundplatte 90 auf, an der durch Federn 92 elastisch ein Aktuatorelement 94 gelagert ist. Auf bzw. an der Grundplatte 90 befindet sich eine Spule 96, in die ein Permanentmagnetelement 98 zumindest teilweise eingetaucht ist, welches seinerseits mit dem Aktuatorelement 94 verbunden ist. In bekannter Weise kann nun durch Anlegen einer elektrischen (insbesondere) Wechselspannung das Permanentmagnetelement 98 vor- und zurückbewegt werden, was über das Aktuatorelement 94 auf die Rückholblattfeder 56 und von dieser, wie in allen zuvor und später noch beschriebenen Ausführungsbeispielen, auf die Bedienplatte 24 übertragen wird.

In dem Ausführungsbeispiel des Tauchspulenaktuators 88 der Fig. 17 wird auf das Aktuatorelement 94 verzichtet. Es wird durch die Rückholblattfeder 56 ersetzt, an der das Permanentmagnetelement 98 angebracht ist. Zusätzlich wird die Grundplatte 90 durch eine Leiterplatine 100 ersetzt, auf der die Spule 96 befestig ist.

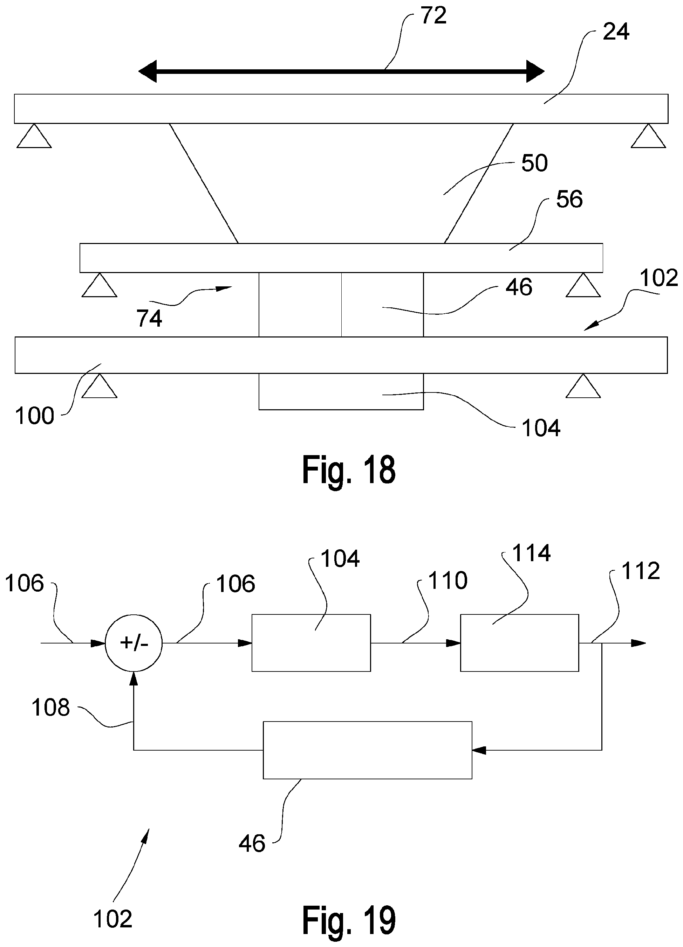

In den Fign. 18 und 19 ist schematisch und als Blockschaltbild ein rückgekoppeltes Ansteuerungssystem 102 für den Aktuator 74 zwecks Regelung der Auslenkung der Bedienplatte 24 bei der puls- bzw. vibrationsartigen Anregung für das aktive haptische Feedback gezeigt. Eine Regelschaltung 104 empfängt an seinem Eingang die Differenz aus einer Soll-Auslenkung 106 und der Ist-Auslenkung 108, die von einem Sensor 46 (z. B. Kraft- oder Wegsensor) erfasst wird und gibt ein Ausgangssignal 110 aus. Die Schaltung 102 gibt ein Ansteuersignal 112 an den Aktuator 74 aus, woraufhin das dynamische System 114 aus den bewegbaren Komponenten des Aktuators 74 und aus Rückholblattfeder 56, Bewegungsübertragungselement 50 und Bedienplatte 24 reagiert, so dass sich die vorgegebene Soll-Auslenkung 106 einstellt.

### BEZUGSZEICHENLISTE

- 10: Instrumententafel
- 12: Innenraum
- 14: Fahrzeug
- 16: Display
- 18: Bedienvorrichtung
- 20: Bedienfelder
- 23: Auflageenden der Bedienplatte
- 24: Bedienplatte
- 25: Längsrandabschnitte der Platte
- 26: Gehäuse
- 28: Vorderseite
- 30: Aussparung
- 32: Schmalränder
- 34: Auflagerandabschnitte
- 36: Lateralrandabschnitt
- 38: Fixierband
- 40: Bedienoberfläche auf der Oberseite der Bedienplatte
- 42: Unterseite der Bedienplatte
- 44: Trägerplatte
- 46: Betätigungssensor
- 48: Unterseite des Gehäuses
- 49: Rahmen
- 50: Bewegungsübertragungselement
- 51: Führungsvorsprung
- 52: Öffnung
- 53: Montagelement
- 54: Montagerandabschnitt
- 55: Blattfederarme
- 56: Blattfeder
- 57: Montageenden der Blattfeder
- 58: Rückholfeder
- 60: unteres Ende des Bewegungsübertragungselements
- 61: Längsrandabschnitt
- 62: Bewegungsspalt
- 64: Hinterleuchtungslichtquellen
- 66: Boden der Aussparung an der Vorderseite des Gehäuses
- 68: Ansteuer- und Auswerteeinheit
- 70: Berührungssensorik
- 72: Bereich der Bedienfelder
- 74: Aktuator
- 76: Abstützung des Aktuators
- 78: Zugankermagnet
- 80: Stator
- 82: Statorspule
- 84: Anker
- 86: piezoelektrisches Element
- 88: Tauchspulenaktuator
- 90: Grundplatte
- 92: Federn
- 94: Aktuatorelement
- 96: Spule
- 98: Permanentmagnetelement
- 100: Leiterplatine
- 102: rückgekoppeltes Ansteuerungssystem
- 104: Regelschaltung
- 106: Soll-Auslenkung
- 108: Ist-Auslenkung
- 110: Ausgangssignal der Regelschaltung
- 112: Ansteuersignal für den Aktuator
- 114: dynamisches System

## Patentansprüche

1. Bedienvorrichtung für ein Fahrzeug, mit
- einem Gehäuse (26), das eine Vorderseite (28) mit einer Aussparung (30) aufweist,
- einer elastischen und/oder direkt oder indirekt elastisch gelagerten Bedienplatte (24), die die Aussparung (30) überdeckt,
- wobei die Bedienplatte (24) reversibel aus einer Ruheposition bis in eine Betätigungsposition niederdrückbar ist und eine Bedienfläche mit Bedienfeldern (20) aufweist,
- einer Positionserkennungssensorik (70) zur Erkennung desjenigen Bedienfeldes (20) der Bedienfläche der Bedienplatte (24), das beim Niederdrücken manuell oder durch ein Objekt kontaktiert ist,
- einer im Gehäuse (26) angeordneten Rückholblattfeder (58) zur Unterstützung der Bewegung der niedergedrückten Bedienplatte (24) zurück in deren Ruheposition,
- mindestens einem Betätigungssensor (46) zur Erkennung der Einnahme der Betätigungsposition der Bedienplatte (24),
- mindestens einem Bewegungsübertragungselement (50) zur Übertragung der Niederdrückbewegung der Bedienplatte (24) in eine Verbiegung der Rückholblattfeder (58),
- wobei das mindestens eine Bewegungsübertragungselement (50) zwischen der Bedienplatte (24) und der Rückholblattfeder (58) angeordnet ist und zwei gegenüberliegende, geradlinige Endabschnitte aufweist, von denen der erste Endabschnitt mit der Bedienplatte (24) und der gegenüberliegende zweite Endabschnitt mit der Rückholblattfeder (58) verbunden ist,
- einer Ansteuer- und Auswerteeinheit (68), die Signale von der Positionserkennungssensorik (70) und dem mindestens einen Betätigungssensor (46) empfängt und bei Erkennung einer validen Betätigung der Bedienplatte (24) durch bei Berührung eines Bedienfeldes (20) der Bedienfläche erfolgender Überführung der Bedienplatte (24) bis in deren Betätigungsposition ein Ausgangssignal für dessen Weiterverarbeitung zur Auslösung einer dem betreffenden Bedienfeld (20) zugeordneten Aktion ausgibt und
- einem Aktuator (74) zur puls- oder vibrationsartigen Anregung der Bedienplatte (24) bei einer validen Betätigung derselben,
- wobei der Aktuator (74) durch ein von der Ansteuer- und Auswerteeinheit (68) bei Erkennung einer validen Betätigung ausgegebenes Ausgangssignal ansteuerbar ist und
- wobei der Aktuator (74) zur puls- oder vibrationsartigen Anregung der Bedienplatte (24) mit der Rückholblattfeder (58) zur Bewegung derselben zusammenwirkt oder auf diese einwirkt,
**dadurch gekennzeichnet,**
- **dass** sich die Aussparung (30) zwischen zwei gegenüberliegenden Auflagerandabschnitten (34) an der Vorderseite (28) des Gehäuses (26) erstreckt und
- **dass** die Bedienplatte (24) zwei gegenüberliegende Auflageenden (23) zur Auflage auf den beiden Auflagerandabschnitten (34) aufweist, an denen die Bedienplatte (24) an dem Gehäuse (26) gelagert und/oder befestigt ist.

2. Bedienvorrichtung nach Anspruch 1, **dadurch gekennzeichnet, dass** der Aktuator (74) als ein Zugankermagnet (78) mit einem im Gehäuse (26) gelagerten, mit einer Spule (82) versehenen Stator (80) und einem ferromagnetischen Anker (84) ausgebildet ist und dass der Anker (84) zur puls- oder vibrationsartigen Anregung der Rückholblattfeder (58) mit dieser verbunden ist.

3. Bedienvorrichtung nach Anspruch 1, **dadurch gekennzeichnet, dass** der Aktuator (74) als ein Zugankermagnet (78) mit einem im Gehäuse (26) befestigten ferromagnetischen Anker (84) und einem mit einer Spule (82) versehenen Stator (80) ausgebildet ist und dass der Stator (80) zur puls- oder vibrationsartigen Anregung der Rückholblattfeder (58) mit dieser verbunden ist.

4. Bedienvorrichtung nach Anspruch 1, **dadurch gekennzeichnet, dass** der Aktuator (74) als ein Zugankermagnet (78) mit einem in dem Gehäuse (26) gelagerten, mit einer Spule (82) versehenen Stator (80) und einem ferromagnetischen Anker aufweist und dass die Rückholblattfeder (58) den ferromagnetischen Anker des Zugankermagneten (78) bildet.

5. Bedienvorrichtung nach Anspruch 1, **dadurch gekennzeichnet, dass** der Aktuator als ein Tauchspulenaktuator(88) ausgebildet ist, der eine im Gehäuse (26) befestigte Grundplatte (90), auf der sich eine Spule (96) befindet, ein federelastisches, an der Grundplatte (90) gelagertes und im Abstand zur Grundplatte (90) angeordnetes Aktuatorelement (94) und ein an dem Aktuatorelement (94) angeordnetes, zumindest teilweise in die Spule (96) eingetauchtes Permanentmagnetelement (98) aufweist und dass das Aktuatorelement (94) zur puls- oder vibrationsartigen Anregung der Rückholblattfeder (58) mit dieser verbunden ist.

6. Bedienvorrichtung nach Anspruch 1, **dadurch gekennzeichnet, dass** der Aktuator als ein Tauchspulenaktuator (88) ausgebildet ist, der eine im Gehäuse (26) befestige Grundplatte (90), auf der oder an der eine Spule (96) montiert ist, und ein zumindest teilweise in die Spule (96) eingetauchtes Permanentmagnetelement (98) aufweist, und dass das Permanentmagnetelement (98) mit der Rückholblattfeder (58) zur puls- oder vibrationsartigen Anregung verbunden ist.

7. Bedienvorrichtung nach Anspruch 5 oder 6, **dadurch gekennzeichnet, dass** die Grundplatte eine Leiterplatine (100) ist und dass die Spule (96) auf der Leiterplatine (100) vorzugsweise durch Lötmaterial befestigt ist.

8. Bedienvorrichtung nach Anspruch 1, **dadurch gekennzeichnet, dass** der Aktuator mindestens ein platten- oder streifenförmiges piezoelektrisches Element (86) mit zwei Hauptflächen sowie mit zwei Anschlusselementen aufweist, wobei das mindestens eine piezoelektrische Element (86) bei einer an die Anschlusselemente angelegten elektrischen Spannung, je nach Polarität, kontrahiert oder expandiert, und dass das mindestens eine piezoelektrische Element (86) mit einer seiner Hauptflächen an der Rückholblattfeder (58) zur puls- oder vibrationsartigen Anregung anliegt sowie mit dieser starr verbunden ist.

9. Bedienvorrichtung nach einem der Ansprüche 1 bis 8, **dadurch gekennzeichnet, dass** die Ansteuer- und Auswerteeinheit (68) einen Regler (104) zur Regelung der Auslenkung der Bedienplatte (24) bei puls- oder vibrationsartiger Anregung derselben infolge einer Aktivierung des Aktuators (74) aufweist, wobei der Regler (104) an seinem Eingang ein Differenzsignal aus einem eine Sollauslenkung (106) der Bedienplatte (24) repräsentierenden Signal und einem das aktuelle Ausmaß der Auslenkung der Bedienplatte (24) repräsentierenden Signal erhält und an seinem Ausgang ein Ansteuersignal (112) für den Aktuator (74) zur Regelung der Auslenkung der Bedienplatte (24) entsprechend der Sollauslegung ausgibt.

10. Bedieneinheit nach einem der Ansprüche 1 bis 9, **dadurch gekennzeichnet, dass** die Rückholblattfeder (58) zwei Enden (57) aufweist, von denen das erste Ende im Gehäuse (26) befestigt ist, wobei die Rückholblattfeder (58) von diesem ersten Ende abstehend angeordnet ist, und dass der zweite Randabschnitt des mindestens einen Bewegungsübertragungselements (50) mit der Rückholblattfeder (58) in dem Bereich zwischen dessen ersten Ende und dessen zweiten Ende oder mit dem zweiten Ende der Rückholblattfeder (58) verbunden ist.

11. Bedieneinheit nach einem der Ansprüche 1 bis 9, **dadurch gekennzeichnet, dass** die Rückholblattfeder (58) zwei Enden (57) aufweist, die beide im Gehäuse (26) befestigt sind, und dass der zweite Randabschnitt des mindestens einen Bewegungsübertragungselements (50) mit der Rückholblattfeder (58) in dem Bereich zwischen deren beiden Enden (57) verbunden ist.

12. Bedieneinheit nach Anspruch 10 und nach Anspruch 8 oder nach einem der vorherigen Ansprüche, sofern auf die Ansprüche 11 und 7 rückbezogen, **dadurch gekennzeichnet, dass** beidseitig des mindestens einen Bewegungsübertragungselements (50) jeweils ein piezoelektrisches Element (56) mit der Rückholblattfeder (58) starr verbunden ist.

13. Bedienvorrichtung nach einem der Ansprüche 1 bis 12, **dadurch gekennzeichnet, dass** die Aussparung (30) an der Vorderseite (28) des Gehäuses (26) einen Boden (66) aufweist, in dem Lichtaustrittsöffnungen oder transparente Bereiche für Hinterleuchtungslicht zum Hinterleuchten der Bedienfelder (20) der Bedienplatte (24) ausgebildet sind, und dass in dem Gehäuse (26) mindestens eine Hinterleuchtungslichtquelle (64) für Hinterleuchtungslicht angeordnet ist.

14. Bedienvorrichtung nach einem der Ansprüche 1 bis 13, **dadurch gekennzeichnet,**
- **dass** der Betätigungssensor ein Weg- oder Kraftsensor oder ein für mechanische Beanspruchungen empfindlicher Sensor ist oder
- **dass** der Betätigungssensor (46) als ein optischer Wegsensor zur Erfassung einer bei einer Durchbiegung der Bedienplatte (24) erfolgenden Änderung des Abstandes des unteren Endes des mindestens einen Bewegungsübertragungselements (50) zu dem Gehäuse (26) und insbesondere zur Unterseite des Gehäuses (26) ausgebildet ist.

15. Bedienvorrichtung nach einem der Ansprüche 1 bis 14, **dadurch gekennzeichnet, dass** die Bedienplatte (24) ein für Hinterleuchtungslicht transparentes Material, wie z.B. Glas oder Kunststoff aufweist.

## Claims

1. An operating device for a vehicle, comprising
- a housing (26) having a front side (28) with a recess (30),
- a flexible operating panel (24) or one flexibly mounted in a direct or indirect manner, that covers the recess (30),
- wherein the operating panel (24) is adapted to be reversibly pressed down from a rest position into an actuation position and has an operating surface with operating fields (20),
- a position detection sensor system (70) for detecting the operating field (20) of the operating surface of the operating panel (24) which is contacted manually or by an object when being pressed down,
- a return leaf spring (58) arranged in the housing (26) to support the movement of the depressed operating panel (24) back to its rest position,
- at least one actuation sensor (46) for detecting when the operating panel (24) assumes the actuation position,
- at least one motion transmission element (50) for transmitting the depression movement of the operating panel (24) into a deflection of the return leaf spring (58),
- wherein the at least one motion transmission element (50) is arranged between the operating panel (24) and the return leaf spring (58) and has two opposite, rectilinear end portions, of which the first end portion is connected to the operating panel (24) and the opposite second end portion is connected to the return leaf spring (58),
- a control and evaluation unit (68) which receives signals from the position detection sensor system (70) and the at least one actuation sensor (46) and, when a valid actuation of the operating panel (24) is detected by transferring the operating panel (24) into its actuation position by touching an operating field (20) of the operating surface, outputs an output signal for further processing thereof to trigger an action associated with the relevant operating field (20), and
- an actuator (74) for pulse- or vibration-like excitation of the operating panel (24) when the latter is validly actuated,
- wherein the actuator (74) is adapted to be controlled by an output signal emitted by the control and evaluation unit (68) when a valid actuation is detected, and
- wherein the actuator (74) interacts with or acts on the return leaf spring (58) to move the latter in order to excite the operating panel (24) in a pulse- or vibration-like manner,
**characterized in that**
- the recess (30) extends between two opposing support edge portions (34) on the front side (28) of the housing (26), and
- the operating panel (24) comprises two opposite support ends (23) for support on the two support edge portions (34), on which the operating panel (24) is mounted and/or attached to the housing (26).

2. The operating device according to claim 1, **characterized in that** the actuator (74) is configured as a tie rod magnet (78) with a stator (80) mounted in the housing (26) and provided with a coil (82) and a ferromagnetic armature (84), and **in that** the armature (84) is connected to the return leaf spring (58) for pulse- or vibration-like excitation of the latter.

3. The operating device according to claim 1, **characterized in that** the actuator (74) is configured as a tie rod magnet (78) with a ferromagnetic armature (84) attached in the housing (26) and a stator (80) provided with a coil (82), and **in that** the stator (80) is connected to the return leaf spring (58) for pulse- or vibration-like excitation of the latter.

4. The operating device according to claim 1, **characterized in that** the actuator (74) is configured as a tie rod magnet (78) with a stator (80) mounted in the housing (26) and provided with a coil (82) and a ferromagnetic armature, and **in that** the return leaf spring (58) forms the ferromagnetic armature of the tie rod magnet (78).

5. The operating device according to claim 1, **characterized in that** the actuator is configured as a plunger coil actuator (88) comprising a base plate (90) which is attached inside the housing (26) and on which a coil (96) is located, a resilient actuator element (94) which is mounted on the base plate (90) and is arranged at a distance from the base plate (90), and a permanent magnet element (98) which is arranged on the actuator element (94) and is at least partially immersed in the coil (96), and **in that** the actuator element (94) is connected to the return leaf spring (58) for pulse- or vibration-like excitation of the latter.

6. The operating device according to claim 1, **characterized in that** the actuator is configured as a plunger coil actuator (88) comprising a base plate (90) which is attached inside the housing (26) and on which or at which a coil (96) is mounted, and a permanent magnet element (98) which is at least partially immersed in the coil (96), and **in that** the permanent magnet element (98) is connected to the return leaf spring (58) for pulse- or vibration-like excitation of the latter.

7. The operating device according to claim 5 or 6, **characterized in that** the base plate is a printed circuit board (100), and **in that** the coil (96) is attached to the printed circuit board (100) preferably by soldering material.

8. The operating device according to claim 1, **characterized in that** the actuator comprises at least one plate-shaped or strip-shaped piezoelectric element (86) with two main surfaces and with two connection elements, wherein the at least one piezoelectric element (86) contracts or expands when an electrical voltage is applied to the connection elements, depending on the polarity, and **in that** the at least one piezoelectric element (86) rests with one of its main surfaces against the return leaf spring (58) for pulse-like or vibration-like excitation and is rigidly connected thereto.

9. The operating device according to any one of claims 1 to 8, **characterized in that** the control and evaluation unit (68) comprises a controller (104) for controlling the deflection of the operating panel (24) in the event of pulse- or vibration-like excitation thereof as a result of activation of the actuator (74), wherein the controller (104) receives at its input a differential signal from a signal representing a target deflection (106) of the operating panel (24) and a signal representing the current extent of the deflection of the operating panel (24) and outputs at its output a control signal (112) for the actuator (74) for controlling the deflection of the operating panel (24) in accordance with the target deflection.

10. The operating unit according to any one of claims 1 to 9, **characterized in that** the return leaf spring (58) has two ends (57), the first end of which is attached in the housing (26), wherein the return leaf spring (58) is arranged to protrude from this first end, and **in that** the second edge portion of the at least one motion transmission element (50) is connected to the return leaf spring (58) in the region between its first end and its second end or to the second end of the return leaf spring (58).

11. The operating unit according to any one of claims 1 to 9, **characterized in that** the return leaf spring (58) has two ends (57), both of which are attached in the housing (26), and **in that** the second edge portion of the at least one motion transmission element (50) is connected to the return leaf spring (58) in the region between its two ends (57).

12. The operating unit according to claim 10 and according to claim 8 or according to any one of the preceding claims, if referred back to claims 11 and 7, **characterized in that** respectively one piezoelectric element (56) is rigidly connected to the return leaf spring (58) on both sides of the at least one motion transmission element (50).

13. The operating device according to any one of claims 1 to 12, **characterized in that** the recess (30) on the front side (28) of the housing (26) has a bottom (66) in which light emission openings or transparent areas for backlighting light are formed for backlighting the operating fields (20) of the operating panel (24), and **in that** at least one backlighting light source (64) for backlighting light is arranged in the housing (26).

14. The operating device according to any one of claims 1 to 13, **characterized in that**
- the actuation sensor is a displacement or force sensor or a sensor sensitive to mechanical stresses, or
- the actuation sensor (46) is configured as an optical displacement sensor for detecting a change in the distance of the lower end of the at least one motion transmission element (50) to the housing (26) and, in particular, to the lower side of the housing (26), which change occurs when the operating panel (24) is deflected.

15. The operating device according to any one of claims 1 to 14, **characterized in that** the operating panel (24) comprises a material transparent to backlighting light, such as glass or plastic.

## Revendications

1. Dispositif de commande pour véhicule, comprenant
- un boîtier (26), qui présente une face avant (28) avec un évidement (30);
- une plaque de commande (24) élastique et/ou montée élastiquement directement ou indirectement, qui recouvre l'évidement (30),
- dans lequel la plaque de commande (24) peut être abaissée de manière réversible d'une position de repos à une position d'actionnement et présente une surface de commande avec des zones de commande (20);
- un capteur de détection de position (70) pour la détection de la zone de commande (20) de la surface de commande de la plaque de commande (24) qui est contactée manuellement ou par un objet lors de l'abaissement,
- un ressort à lame de rappel (58) disposé dans le boîtier (26) pour soutenir le mouvement de la plaque de commande (24) abaissée dans sa position de repos,
- au moins un capteur d'actionnement. (46) pour détecter l'entrée dans la position d'actionnement de la plaque de commande (24),
- au moins un élément de conversion de mouvement (50) pour la conversion du mouvement d'abaissement de la plaque de commande (24) en une flexion du ressort à lame de rappel (58),
- dans lequel le au moins un élément de conversion de mouvement (50) est disposé entre la plaque de commande (24) et le ressort à lame de rappel (58) et présente deux sections d'extrémité rectilignes opposées, parmi lesquelles la première section d'extrémité est reliée à la plaque de commande (24) et la seconde section d'extrémité opposée est reliée au ressort à lame de rappel (58),
- une unité de commande et d'évaluation (68), qui reçoit des signaux du capteur de détection de position (70) et du au moins un capteur d'actionnement (46) et, lors de la détection d'un actionnement valide de la plaque de commande (24) par transfert de la plaque de commande (24) jusque dans sa position d'actionnement par contact d'une zone de commande (20) de la surface de commande, émet un signal de sortie pour son traitement ultérieur pour déclencher une action assignée à la zone de commande (20) concernée et
- un actionneur (74) pour l'excitation par impulsion ou vibration de la plaque de commande (24) lors d'un actionnement valide de celle-ci,
- dans lequel l'actionneur (74) peut être commandé par un signal de sortie émis par l'unité de commande et d'évaluation (68) lors de la détection d'un actionnement valide et
- dans lequel l'actionneur (74) pour l'excitation par impulsion ou vibration de la plaque de commande (24) coopère avec le ressort à lame de rappel (58) ou agit sur celui-ci pour son déplacement,
**caractérisé**
- **en ce que** l'évidement (30) s'étend entre deux sections de bord de support opposées (34) sur la face avant (28) du boîtier (26) et
- **en ce que** la plaque de commande (24) présente deux extrémités de support opposées (23) pour l'appui sur les deux sections de support (34) au niveau desquelles la plaque de commande (24) est montée et/ou fixée au boîtier (26).

2. Dispositif de commande selon la revendication 1, **caractérisé en ce que** l'actionneur (74) est conçu comme un aimant à armature de traction (78) avec un stator (80) muni d'une bobine (82) monté dans le boîtier (26), et une armature ferromagnétique (84), et **en ce que** l'armature (84) est reliée au ressort à lame de rappel (58) pour l'excitation par impulsions ou vibrations de celui-ci.

3. Dispositif de commande selon la revendication 1, **caractérisé en ce que** l'actionneur (74) est conçu comme un aimant à armature de traction (78) avec une armature ferromagnétique (84) fixée dans le boîtier (26) et un stator (80) muni d'une bobine (82) et **en ce que** le stator (80) est relié au ressort à lame de rappel (58) pour l'excitation par impulsions ou vibrations de celui-ci.

4. Dispositif de commande selon la revendication 1, **caractérisé en ce que** l'actionneur (74) présente un aimant à armature de traction (78) avec un stator (80) muni d'une bobine (82) monté dans le boîtier (26), et une armature ferromagnétique et **en ce que** le ressort à lame de rappel (58) forme l'armature ferromagnétique de l'aimant à armature de traction (78).

5. Dispositif de commande selon la revendication 1, **caractérisé en ce que** l'actionneur est conçu comme un actionneur à bobine mobile (88), qui présente une plaque de base (90) fixée dans le boîtier (26), sur laquelle se trouve une bobine (96), un élément d'actionnement élastique (94) monté sur la plaque de base (90) et disposé à distance de la plaque de base (90), et un élément magnétique permanent (98) disposé sur l'élément d'actionnement (94), au moins partiellement immergé dans la bobine (96), et **en ce que** l'élément d'actionnement (94) est relié au ressort à lame de rappel (58) pour l'excitation par impulsions ou vibrations de celui-ci.

6. Dispositif de commande selon la revendication 1, **caractérisé en ce que** l'actionneur est conçu comme un actionneur à bobine mobile (88) qui présente une plaque de base (90) fixée dans le boîtier (26), sur laquelle ou contre laquelle est montée une bobine (96), et un élément magnétique permanent (98) au moins partiellement immergé dans la bobine (96), et **en ce que** l'élément magnétique permanent (98) est relié au ressort à lame de rappel (58) pour l'excitation par impulsions ou vibrations.

7. Dispositif de commande selon la revendication 5 ou 6, **caractérisé en ce que** la plaque de base est un circuit imprimé (100) et **en ce que** la bobine (96) est fixée au circuit imprimé (100) de préférence par soudure.

8. Dispositif de commande selon la revendication 1, **caractérisé en ce que** l'actionneur présente au moins un élément piézoélectrique (86) en forme de plaque ou de bande avec deux surfaces principales ainsi qu'avec deux éléments de connexion, dans lequel le au moins un élément piézoélectrique (86) se contracte ou se dilate, selon la polarité, lorsqu'une tension électrique est appliquée aux éléments de connexion, et **en ce que** le au moins un élément piézoélectrique (86) repose avec l'une de ses surfaces principales contre le ressort à lame de rappel (58) pour l'excitation par impulsions ou vibrations et est relié rigidement à celui-ci.

9. Dispositif de commande selon l'une des revendications 1 à 8, **caractérisé en ce que** l'unité de commande et d'évaluation (68) présente un régulateur (104) pour réguler la déflexion de la plaque de commande (24) lors d'une excitation par impulsions ou vibrations de celle-ci, par suite d'une activation de l'actionneur (74), dans lequel le régulateur (104) reçoit à son entrée un signal différentiel composé d'un signal représentant une déflexion cible (106) de la plaque de commande (24) et d'un signal représentant l'ampleur actuelle de la déflexion de la plaque de commande (24) et génère à sa sortie un signal de commande (112) pour l'actionneur (74) pour réguler la déflexion de la plaque de commande (24) conformément à la consigne.

10. Unité de commande selon l'une des revendications 1 à 9, **caractérisée en ce que** le ressort à lame de rappel (58) présente deux extrémités (57), parmi lesquelles la première extrémité est fixée dans le boîtier (26), dans laquelle le ressort à lame de rappel (58) est disposé à distance de cette première extrémité, et **en ce que** la seconde section de bord du au moins un élément de conversion de mouvement (50) est reliée au ressort à lame de rappel (58) dans la zone entre sa première extrémité et sa seconde extrémité ou à la seconde extrémité du ressort à lame de rappel (58).

11. Unité de commande selon l'une des revendications 1 à 9, **caractérisée en ce que** le ressort à lame de rappel (58) présente deux extrémités (57), qui sont toutes deux fixées dans le boîtier (26), et **en ce que** la seconde section de bord du au moins un élément de conversion de mouvement (50) est reliée au ressort à lame de rappel (58) dans la zone entre ses deux extrémités (57).

12. Unité de commande selon la revendication 10 et selon la revendication 8 ou selon l'une des revendications précédentes, dans la mesure où elles se réfèrent aux revendications 11 et 7, **caractérisée en ce que**, de part et d'autre du au moins un élément de conversion de mouvement (50), un élément piézoélectrique (56) est relié rigidement au ressort à lame de rappel (58).

13. Dispositif de commande selon l'une des revendications 1 à 12, **caractérisé en ce que** l'évidement (30) présente sur la face avant (28) du boîtier (26) un fond (66) dans lequel sont formées des ouvertures d'émission de lumière ou des zones transparentes pour la lumière de rétroéclairage pour rétroéclairer les zones de commande (20) de la plaque de commande (24), et **en ce qu'**au moins une source de lumière de rétroéclairage (64) est disposée dans le boîtier (26) pour la lumière de rétroéclairage.

14. Dispositif de commande selon l'une quelconque des revendications 1 à 13, **caractérisé**
- **en ce que** le capteur d'actionnement est un capteur de déplacement ou de force ou un capteur sensible aux contraintes mécaniques ou
- **en ce que** le capteur d'actionnement (46) est conçu comme un capteur de déplacement optique pour détecter une modification qui se produit lors de la flexion la plaque de commande (24) de la distance de l'extrémité inférieure du au moins un élément de conversion de mouvement (50) au boîtier (26), et en particulier à la face inférieure du boîtier (26).

15. Dispositif de commande selon l'une des revendications 1 à 14, **caractérisé en ce que** la plaque de commande (24) présente un matériau transparent pour la lumière de rétroéclairage, comme le verre ou le plastique par exemple.
